# EUROPEAN PATENT SPECIFICATION

(11) **EP 3 495 534 B1**
(45) Date of publication and mention of the grant of the patent: **22.07.2020**
(21) Application number: 18204550.0
(22) Date of filing: 06.11.2018
(51) Int. Cl.: H01J 37/32, H01J 37/34, B65H 23/188, C23C 14/35, C23C 14/56, C23C 14/20, C23C 14/50, C23C 14/54

(54) **LONG SUBSTRATE TREATMENT APPARATUS AND TREATMENT METHOD**
VORRICHTUNG UND VERFAHREN ZUR BEHANDLUNG VON EINEM LANGEN SUBSTRAT
APPAREIL ET PROCÉDÉ DE TRAITEMENT D'UN SUBSTRAT LONG

(30) Priority: 11.12.2017 JP 2017236841
(43) Date of publication of application: 12.06.2019
(73) Proprietor: Sumitomo Metal Mining Co., Ltd., Tokyo 105-8716 (JP)
(72) Inventor: OKAMI, Hideharu, Niihama-shi, Ehime 792-0008 (JP)
(74) Representative: TBK

(56) References cited:
- WO-A1-2015/110154
- JP-A- 2006 249 471
- JP-A- 2012 132 081

## Description

### BACKGROUND OF THE INVENTION

### 1. Field of the Invention

The present invention relates to a long substrate treatment apparatus and treatment method for performing a treatment that applies a thermal load such as ion beam treatment or sputtering deposition on a long substrate such as a heat-resistant resin film transferred through a vacuum chamber in a roll-to-roll manner and wrapped on the outer peripheral surface of a can roll with a gas discharge mechanism, and relates in particular to a long substrate treatment apparatus and treatment method by which a long substrate is less prone to formation of wrinkles, scratches, and the like.

### 2. Description of the Related Art

Flexible wiring substrates are used in liquid crystal panels, laptop computers, digital cameras, mobile phones, and so on. A flexible wiring substrate is fabricated from a metal film-coated heat-resistant resin film obtained by forming a metal film on one or both surfaces of heat-resistant resin film. In recent years, wiring patterns formed on flexible wiring substrates have increasingly become finer and denser and it has become more important for metal film-coated heat-resistant resin films themselves to be flat and smooth with no wrinkles or the like.

Conventional methods of manufacturing this type of metal film-coated heat-resistant resin film have known such as: a manufacturing method in which a metal foil is attached to a heat-resistant resin film with an adhesive (referred to as the three-layer substrate manufacturing method); a manufacturing method in which a metal foil is coated with a heat-resistant resin solution and then the resin solution is dried (referred to as the casting method); and a manufacturing method in which a metal film is formed on a heat-resistant resin film by a dry plating method (vacuum deposition method) or a combination of a dry plating method (vacuum deposition method) and a wet plating method (referred to as the metallizing method). Also, the dry plating method (vacuum deposition method) in the metallizing method includes vacuum vapor deposition methods, sputtering methods, ion plating methods, ion beam sputtering methods, and so on.

As the metallizing method, Patent Document 1 discloses a method in which chromium is sputtered onto a polyimide insulating layer and then copper is sputtered to form a conductive layer on the polyimide insulating layer. Also, Patent Document 2 discloses a flexible circuit board material formed by sequentially laminating a first metal thin film formed by sputtering a target of a copper-nickel alloy and a second metal thin film formed by sputtering a target of copper onto a polyimide film. Note that a sputtering web coater is usually used to perform vacuum deposition on a heat-resistant resin film (substrate) such as a polyimide film.

Generally, among the vacuum deposition methods mentioned above, the sputtering methods have been said to provide better bond but apply a larger thermal load to the heat-resistant resin film than the vacuum vapor deposition methods. Moreover, it has also been known that applying a large thermal load to the heat-resistant resin film during the deposition makes the film more prone to formation of wrinkles. To prevent the formation of the wrinkles, sputtering web coaters as apparatuses for manufacturing a metal film-coated heat-resistant resin film are equipped with a can roll having a cooling function, and employ an method in which this can roll is rotationally driven while a heat-resistant resin film transferred in a roll-to-roll manner is wrapped on a transfer path defined on the outer peripheral surface of the can roll, to thereby cool the heat-resistant resin film from its back surface during the sputtering process.

For example, Patent Document 3 discloses an unwinding-winding type (roll-to-roll type) vacuum sputtering apparatus as an example of the sputtering web coaters. This unwinding-winding type vacuum sputtering apparatus includes a cooling roll that serves as the above can roll, and performs control that brings a film into tight contact with the cooling roll by using an additional sub roll provided at least on the film infeed side or the film outfeed side of the cooling roll.

However, as described in Non-Patent Document 1, the outer peripheral surface of the can roll is not flat when viewed microscopically. Thus, between the can roll and the film transferred in tight contact with its outer peripheral surface, gap regions (clearances) are present which separate them with a vacuum space therebetween. Accordingly, it cannot be said that the heat in the film generated during sputtering or vapor deposition is actually efficiently transferred to the can roll from the film. This has been a cause of the formation of film wrinkles.

To solve this, a technique has been proposed in which a gas is introduced into the gap regions between the outer peripheral surface of the can roll and the film from the can roll side to thereby make the thermal conductivity of the gap regions higher than the vacuum.

Further, as specific methods of introducing a gas into the gap regions from the can roll side, for example Patent Document 4 discloses a technique in which many small holes are provided in the outer peripheral surface of a can roll as gas discharge ports, and Patent Document 5 discloses a technique in which grooves are provided in the outer peripheral surface of a can roll as gas discharge ports. Moreover, a method in which a can roll itself is made from a porous body and the small holes in the porous body itself are used as gas discharge ports.

Meanwhile, in methods in which small holes, grooves, or the like are provided in the outer peripheral surface of a can roll as gas discharge ports, the resistance at the gas discharge ports are lower in the region of the outer peripheral surface of the can roll where the film is not wrapped (non-wrapped portion region) than in the region where the film is wrapped (wrapped portion region). This sometimes leads to a situation where the gas supplied to the can roll is mostly discharged to the space in the vacuum chamber from the gas discharge ports in the non-wrapped portion region, which results in a failure to supply the amount of gas that is supposed to be introduced into the gap regions between the outer peripheral surface of the can roll and the film wrapped thereon, and thus makes it impossible to achieve the thermal conductivity enhancing effect mentioned above.

To solve this problem, methods have been proposed such as: a method in which valves that project from the outer peripheral surface of a can roll are provided in gas discharge ports, and the gas discharge ports are opened by pressing a film surface against the respective valves (Patent Document 5); and a method in which a cover is attached to the region of the outer peripheral surface of a can roll where a film is not wrapped (the non-wrapped portion region of the outer peripheral surface of the can roll) to thereby prevent discharge of a gas from the non-wrapped portion region to the space in the vacuum chamber and thus efficiently introduce the gas into the gap regions between the outer peripheral surface of the can roll and the film surface (see Patent Document 6).

However, with the method of Patent Document 5, in which the gas discharge ports are opened by pressing the film surface against the respective valves projecting from the outer peripheral surface of the can roll, there is a possibility that the film surface is slightly damaged or dented by its contact with the valves. Thus, it is difficult to employ the method of Patent Document 5 for manufacturing flexible wiring substrates for electronic devices that are required to have high quality. Also, with the method of Patent Document 6, in which a cover is attached to the region of the outer peripheral surface of a can roll where a film is not wrapped (non-wrapped portion region), gas is likely to leak from the clearance between the cover and the outer peripheral surface of the can roll in a treatment apparatus that performs deposition under high vacuum. Thus, like the method of Patent Document 5, it is difficult to employ the method of Patent Document 6.

Under these technical circumstances, the present inventor has already proposed a can roll with a structure that does not supply a gas to the outer peripheral surface of the can roll at the region where the film is not wrapped (non-wrapped portion region) to thereby prevent discharge of the gas from the non-wrapped portion region (see Patent Document 7). Specifically, as illustrated in FIG. 9, this can roll is a can roll 56 provided with a plurality of gas introduction channels 14 in a thick portion of the can roll 56, many gas discharge holes 15 are provided in each gas introduction channel 14, and the can roll 56 is controlled so as to supply a gas from outside the vacuum chamber selectively to the gas introduction channels 14 through a rotary joint 20 including a fixed ring unit 22 and a rotary ring unit 21.

Meanwhile, in Non-Patent Document 2, it is reported that, in a case where the introduced gas is an argon gas and the pressure of the introduced gas is 500 Pa, then, when the gap regions (clearances) between the outer peripheral surface of a can roll and a film wrapped on the outer peripheral surface of the can roll are molecular flow regions measuring approximately 40 µm or shorter in distance, the thermal conductance of the gap regions is 250 (W/m²·K) (see page 752 of Non-Patent Document 2).

Further, for a long substrate treatment apparatus employing the can roll 56 with a gas discharge mechanism in Patent Document 7 too, the higher the gas pressure in the gap regions between the outer peripheral surface of the can roll and a film (long substrate) 52 at the wrapped portion region, the higher the thermal conductance (the efficiency of heat transfer by molecular flows) and therefore the higher the efficiency of the cooling of the long substrate 52.

However, if the gas pressure in the gap regions is higher than a reaction P = T/R (R: the radius of the can roll) which is a force with which the long substrate 52 is pressed against the can roll 56 under a tension T in the direction of transfer of the long substrate 52, the long substrate 52 floats from the outer peripheral surface of the can roll 56, which makes it difficult to control the gas pressure. It is therefore important to control the gas pressure in the gap regions between the outer peripheral surface of the can roll 56 and the long substrate 52, and also important to control the tension of the long substrate 52 during its transfer simultaneously with the gas pressure control.

Thus, in the long substrate treatment apparatus employing the can roll with a gas discharge mechanism, the pressure of the gas to be introduced into the gap regions is controlled to be slightly lower than the reaction P (the force with which the long substrate 52 is pressed against the can roll 56) so as to satisfy conditions for the gas pressure and the tension. This brings the gas pressure and the reaction P into equilibrium and thus makes the friction force (grip force) between the can roll 56 and the long substrate 52 extremely low. Then, without accurately controlling the tensions of the long substrate 52 transferred upstream and downstream of the can roll 56, the long substrate 52 may possibly slip on the surface of the can roll 56 and scratches may possibly be formed on the long substrate 52.

### CONVENTIONAL ART DOCUMENTS

### PATENT DOCUMENTS

Patent Document 1: Japanese Patent Application Publication No. Hei 2-98994
Patent Document 2: Japanese Patent No. 3447070
Patent Document 3: Japanese Patent Application Publication No. Sho 62-247073
Patent Document 4: Pamphlet of International Publication No. WO2005/001157
Patent Document 5: Specification of U.S. Patent No. 3414048
Patent Document 6: Pamphlet of International Publication No. 2002/070778
Patent Document 7: Japanese Patent Application Publication No. 2012-132081, which discloses a long substrate treatment apparatus and a corresponding long substrate treatment method according to the preambles of claims 1 and 6.

### NON-PATENT DOCUMENTS

Non-Patent Document 1: "Vacuum Heat Transfer Models for Web Substrates: Review of Theory and Experimental Heat Transfer Data", 2000 Society of Vacuum Coaters, 43rd Annual Technical Conference Proceeding, Denver, April 15-20, 2000, p.335
Non-Patent Document 2: "Improvement of Web Condition by the Deposition Drum Design", 2000 Society of Vacuum Coaters, 50th Annual Technical Conference Proceeding (2007), p.749

### SUMMARY OF THE INVENTION

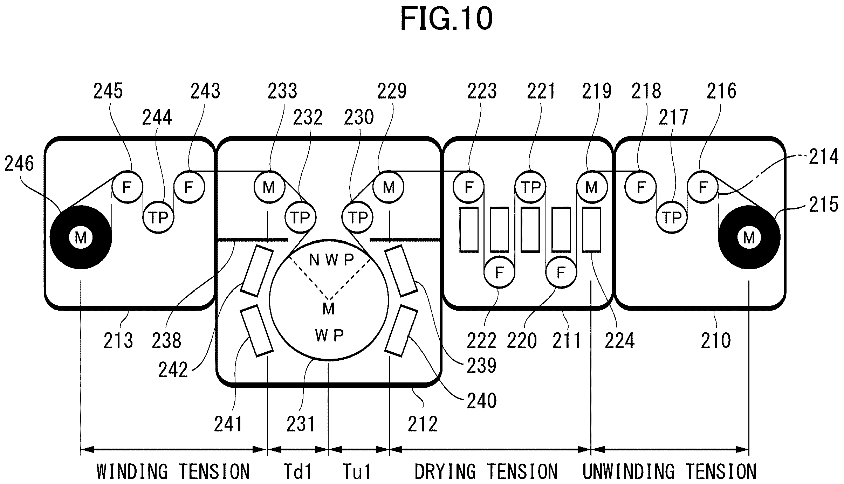

However, contrary to the above demand for long substrate tension control, large-scale sputtering web coaters (long substrate treatment apparatuses) have difficulty in accurately controlling the tensions of a long substrate transferred upstream and downstream of a can roll. This is because, as illustrated in FIG. 10, large-scale sputtering web coaters include an unwinding chamber 210 that includes an unwinding roll 215 therein and unwinds a heat-resistant resin film (long substrate) 214 before deposition, a drying chamber 211 that dries the long substrate 214 before the deposition, a deposition chamber 212 that includes therein magnetron sputtering cathodes 239, 240, 241, and 242 and a can roll 231 with a gas discharge mechanism and forms a metal film or the like on the long substrate 214 transferred from the drying chamber 211, a winding chamber 213 that includes a winding roll 246 therein and winds the long substrate 214 after the deposition transferred from the deposition chamber 212, and so on, and the tension of the long substrate 214 transferred through these zones is set differently from one zone to another.

For example, the unwinding tension of the long substrate 214 in the unwinding chamber 210, illustrated in FIG. 10, (a tension based on the difference in circumferential speed between the unwinding roll 215 and a motor driven roll 219 in the drying chamber 211) is measured by a tension measurement roll 217 in the unwinding chamber 210, and the measurement data is fed back to the unwinding roll 215 to control the circumferential speed of the unwinding roll 215.

The drying tension of the long substrate 214 in the drying chamber 211 (a tension based on the difference in circumferential speed between the motor driven roll 219 and an infeed-side motor driven roll 229 in the deposition chamber 212) is measured by a tension measurement roll 221 in the drying chamber 211, and the measurement data is fed back to the motor driven roll 219 to control the circumferential speed of the motor driven roll 219.

Also, an infeed tension Tu1 of the long substrate 214 in the deposition chamber 212 (a tension based on the difference in circumferential speed between the infeed-side motor driven roll 229 and the can roll 231) is measured by an infeed-side tension measurement roll 230 in the deposition chamber 212, and the measurement data is fed back to the infeed-side motor driven roll 229 to control the circumferential speed of the infeed-side motor driven roll 229. Moreover, an outfeed tension Td1 of the long substrate 214 in the deposition chamber 212 (a tension based on the difference in circumferential speed between the can roll 231 and an outfeed-side motor driven roll 233 in the deposition chamber 212) is measured by an outfeed-side tension measurement roll 232 in the deposition chamber 212, and the measurement data is fed back to the outfeed-side motor driven roll 233 to control the circumferential speed of the outfeed-side motor driven roll 233.

Further, the winding tension of the long substrate 214 in the winding chamber 213 (a tension based on the difference in circumferential speed between the outfeed-side motor driven roll 233 in the deposition chamber 212 and the winding roll 246 in the winding chamber 213) is measured by a tension measurement roll 244 in the winding chamber 213, and the measurement data is fed back to the winding roll 246 to control the circumferential speed of the winding roll 246.

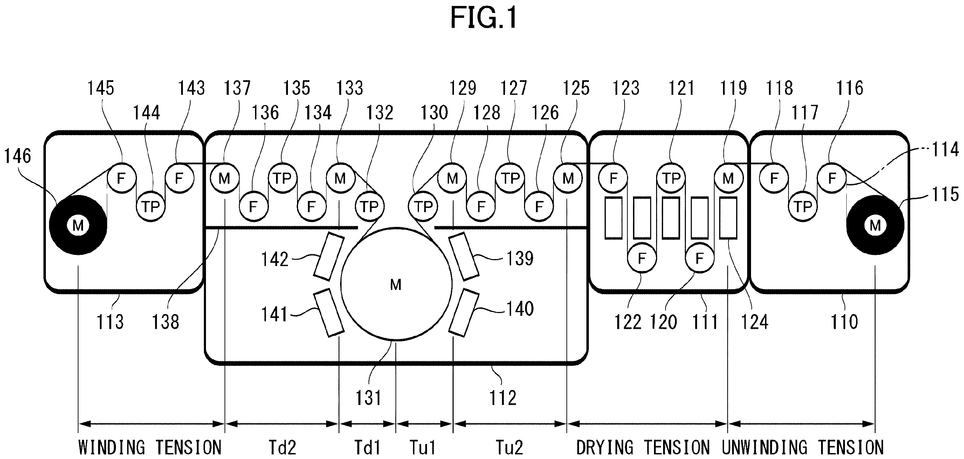

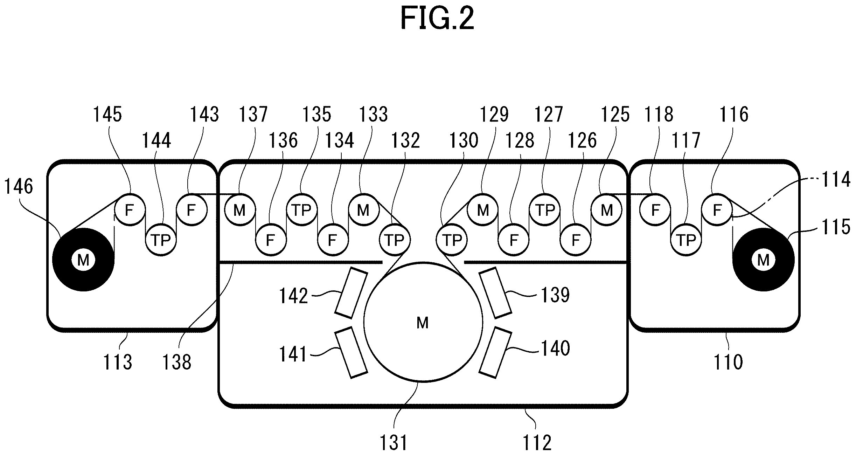

Here, in FIG. 10, the motor driven rolls (including the unwinding roll 215, the can roll 231, and the winding roll 246) are denoted by reference sign M (motor), the tension measurement rolls are denoted by reference sign TP (tension pick up), and the free rolls are denoted by reference sign F (free) (the same applies to FIGS. 1 and 2). Also, in FIG. 10, the long substrate 214 unwound from the unwinding roll 215 is illustrated using two ways of unwinding with a solid line and a chain line, and the long substrate 214 wound around the winding roll 246 is also illustrated using two ways with a solid line and a chain line.

Further, the tension of the long substrate 214 transferred through the zones of the unwinding chamber 210, the drying chamber 211, the deposition chamber 212, and the winding chamber 213 is set differently from one zone to another. There are cases where, for example, the drying tension of the long substrate 214 transferred through the drying chamber 211 is set to 30 N (newton) and the infeed tension and outfeed tension of the long substrate 214 transferred through the deposition chamber 212 are set to 200 N. This large tension difference is controlled by the motor driven rolls, the motor driven can roll, and so on. However, with the large tension difference, the problem is that it is difficult to control that tension difference with the motor driven rolls, the can roll, and so on, which causes slippage, vibration, or the like of the long substrate 214 on the surface of the can roll 231, thereby making the tension unstable and forming scratches or the like on the long substrate 214.

In the sputtering web coater (long substrate treatment apparatus) illustrated in FIG. 10, the zones of the unwinding chamber 210, the drying chamber 211, the deposition chamber 212, and the winding chamber 213 are provided in respective individual chambers. Note that the above problem occurs similarly with long substrate treatment apparatuses in which an unwinding zone, a drying zone, a deposition zone, and a winding zone are provided in a single chamber.

The present invention has been made in view of such a problem and an object thereof is to provide a long substrate treatment apparatus and treatment method by which a long substrate is less prone to formation of wrinkles, scratches, and the like by performing two-stage control on the tension of the long substrate infed toward a can roll with a gas discharge mechanism in the direction of the infeed (infeed tension) and on the tension of the long substrate outfeed from the can roll in the direction of the outfeed (outfeed tension) with two pairs of tension control roll groups provided on the infeed side and the outfeed side of the can roll, respectively.

That is, a first aspect according to the present invention is a long substrate treatment apparatus which includes:
an unwinding zone in which to unwind a long substrate wound around an unwinding roll;
a treatment zone in which to perform a treatment that applies a thermal load in a vacuum chamber on the long substrate fed from the unwinding zone; and
a winding zone in which to wind the long substrate subjected to the treatment,
the treatment zone including
   a motor driven can roll that cools the long substrate transferred in a roll-to-roll manner and wrapped on an outer peripheral surface of the can roll,
   an infeed-side tension control roll group and an outfeed-side tension control roll group provided on an infeed side and an outfeed side of the can roll where the long substrate is infed toward and outfed from the can roll, respectively, and
   thermal load applying treatment means positioned so as to face the outer peripheral surface of the can roll,
a plurality of gas introduction channels being arranged over an entire circumference of the can roll at substantially equal intervals in a circumferential direction, the plurality of gas introduction channels each including a plurality of gas discharge holes opening toward the outer peripheral surface at substantially equal intervals along a direction of a rotary shaft of the can roll, and
the long substrate treatment apparatus including a rotary joint that supplies a gas from outside the vacuum chamber to the gas introduction channels situated within an angular range of the outer peripheral surface of the can roll within which the long substrate is wrapped, and does not supply the gas from outside the vacuum chamber to the gas introduction channels not situated within the angular range within which the long substrate is wrapped,
characterized in that
the infeed-side tension control roll group includes a first infeed-side tension control roll group and a second infeed-side tension control roll group each provided in the treatment zone, the first infeed-side tension control roll group including a first infeed-side tension measurement roll disposed near the infeed side of the can roll and a first infeed-side motor driven roll whose circumferential speed is controlled based on a tension of the long substrate measured by the first infeed-side tension measurement roll, the second infeed-side tension control roll group including a second infeed-side tension measurement roll disposed on the first infeed-side motor driven roll side and a second infeed-side motor driven roll whose circumferential speed is controlled based on a tension of the long substrate measured by the second infeed-side tension measurement roll,
the outfeed-side tension control roll group includes a first outfeed-side tension control roll group and a second outfeed-side tension control roll group each provided in the treatment zone, the first outfeed-side tension control roll group including a first outfeed-side tension measurement roll disposed near the outfeed side of the can roll and a first outfeed-side motor driven roll whose circumferential speed is controlled based on a tension of the long substrate measured by the first outfeed-side tension measurement roll, the second outfeed-side tension control roll group including a second outfeed-side tension measurement roll disposed on the first outfeed-side motor driven roll side and a second outfeed-side motor driven roll whose circumferential speed is controlled based on a tension of the long substrate measured by the second outfeed-side tension measurement roll,
a tension of the long substrate infed toward the can roll in the direction of the infeed is adjusted by two-stage control using an infeed tension (Tu1) set based on a difference in circumferential speed between the can roll and the first infeed-side motor driven roll and an infeed tension (Tu2) (Tu1 > Tu2) set based on a difference in circumferential speed between the first infeed-side motor driven roll and the second infeed-side motor driven roll, and
a tension of the long substrate outfed from the can roll in the direction of the outfeed is adjusted by two-stage control using an outfeed tension (Td1) set based on a difference in circumferential speed between the first outfeed-side motor driven roll and the can roll, and an outfeed tension (Td2) (Td1 > Td2) set based on a difference in circumferential speed between the second outfeed-side motor driven roll and the first outfeed-side motor driven roll.

Also, a second aspect of the present invention is the long substrate treatment apparatus according to the first aspect, characterized in that
the rotary joint includes a rotary ring unit and a fixed ring unit provided coaxially with the can roll and each including a gas control sliding contact surface formed perpendicularly to a center axis of the can roll,
the rotary ring unit includes a plurality of gas supply channels communicating with the plurality of gas introduction channels in the can roll, respectively, the plurality of gas supply channels each including a revolving opening portion at the gas control sliding contact surface of the rotary ring unit, the revolving opening portion opening at an angular position corresponding to an angular position, on the outer peripheral surface of the can roll, of the gas introduction channel communicating with the gas supply channel,
the fixed ring unit includes a gas distribution channel formed by an annular recessed groove, including a fixed closed portion and a fixed opening portion, and communicating with a supply pipe outside the vacuum chamber, the annular recessed groove being provided in the gas control sliding contact surface of the fixed ring unit so as to extend in the circumferential direction, the fixed closed portion being a portion at which the gas control sliding contact surface of the fixed ring unit is closed by an arched packing member fitted in a predetermined region inside the annular recessed groove, the fixed opening portion being a portion at which the gas control sliding contact surface is not closed, and
the fixed opening portion opens within an angular range in a region on the gas control sliding contact surface of the fixed ring unit which the revolving opening portions of the rotary ring unit face, the angular range being a range within which the long substrate is wrapped.

A third aspect is the long substrate treatment apparatus according to the first aspect, characterized in that
the rotary joint includes a rotary ring unit having a T-shaped cross section and including a cylindrical base part and a cylindrical protruding part provided coaxially with the can roll, and a cylindrical fixed ring unit in which the cylindrical protruding part of the rotary ring unit is fitted such that the cylindrical protruding part of the rotary ring unit and the fixed ring unit each include a gas control sliding contact surface in parallel to a center axis of the can roll,
the rotary ring unit includes a plurality of gas supply channels communicating with the plurality of gas introduction channels in the can roll, respectively, the plurality of gas supply channels each including a revolving opening portion at the gas control sliding contact surface of the cylindrical protruding part of the rotary ring unit, the revolving opening portion opening at an angular position corresponding to an angular position, on the outer peripheral surface of the can roll, of the gas introduction channel communicating with the gas supply channel,
the fixed ring unit includes a gas distribution channel formed by an annular recessed groove, including a fixed closed portion and a fixed opening portion, and communicating with a supply pipe outside the vacuum chamber, the annular recessed groove being provided in a cylindrical inner circumferential surface of the fixed ring unit so as to extend in the circumferential direction, the fixed closed portion being a portion at which the gas control sliding contact surface of the fixed ring unit is closed by an arched packing member fitted in a predetermined region inside the annular recessed groove, the fixed opening portion being a portion at which the gas control sliding contact surface is not closed, and
the fixed opening portion opens within an angular range in a region on the gas control sliding contact surface of the fixed ring unit which the revolving opening portions of the cylindrical protruding part of the rotary ring unit face, the angular range being a range within which the long substrate is wrapped.

Further, a fourth aspect according to the present invention is the long substrate treatment apparatus according to any one of the first to third aspects, characterized in that the treatment that applies a thermal load is a treatment with vacuum deposition means facing a transfer path defined on the outer peripheral surface of the can roll.

A fifth aspect is the long substrate treatment apparatus according to the fourth aspect, characterized in that the vacuum deposition means includes a magnetron sputtering cathode.

Also, a sixth aspect according to the present invention is a long substrate treatment method which uses
an unwinding zone in which to unwind a long substrate wound around an unwinding roll,
a treatment zone in which to perform a treatment that applies a thermal load in a vacuum chamber on the long substrate fed from the unwinding zone, and
a winding zone in which to wind the long substrate subjected to the treatment,
the long substrate treatment method including
forming the treatment zone from
a motor driven can roll that cools the long substrate transferred in a roll-to-roll manner and wrapped on an outer peripheral surface of the can roll,
an infeed-side tension control roll group and an outfeed-side tension control roll group provided on an infeed side and an outfeed side of the can roll where the long substrate is infed toward and outfed from the can roll, respectively, and
thermal load applying treatment means positioned so as to face the outer peripheral surface of the can roll,
arranging a plurality of gas introduction channels over an entire circumference of the can roll at substantially equal intervals in a circumferential direction, the plurality of gas introduction channels each including a plurality of gas discharge holes opening toward the outer peripheral surface at substantially equal intervals along a direction of a rotary shaft of the can roll, and
providing the can roll with a rotary joint to supply a gas from outside the vacuum chamber to the gas introduction channels situated within an angular range of the outer peripheral surface of the can roll within which the long substrate is wrapped, and not to supply the gas from outside the vacuum chamber to the gas introduction channels not situated within the angular range within which the long substrate is wrapped,
characterized in that the long substrate treatment method includes:
forming the infeed-side tension control roll group from a first infeed-side tension control roll group and a second infeed-side tension control roll group each provided in the treatment zone, the first infeed-side tension control roll group including a first infeed-side tension measurement roll disposed near the infeed side of the can roll and a first infeed-side motor driven roll whose circumferential speed is controlled based on a tension of the long substrate measured by the first infeed-side tension measurement roll, the second infeed-side tension control roll group including a second infeed-side tension measurement roll disposed on the first infeed-side motor driven roll side and a second infeed-side motor driven roll whose circumferential speed is controlled based on a tension of the long substrate measured by the second infeed-side tension measurement roll;
forming the outfeed-side tension control roll group from a first outfeed-side tension control roll group and a second outfeed-side tension control roll group each provided in the treatment zone, the first outfeed-side tension control roll group including a first outfeed-side tension measurement roll disposed near the outfeed side of the can roll and a first outfeed-side motor driven roll whose circumferential speed is controlled based on a tension of the long substrate measured by the first outfeed-side tension measurement roll, the second outfeed-side tension control roll group including a second outfeed-side tension measurement roll disposed on the first outfeed-side motor driven roll side and a second outfeed-side motor driven roll whose circumferential speed is controlled based on a tension of the long substrate measured by the second outfeed-side tension measurement roll;
adjusting a tension of the long substrate infed toward the can roll in the direction of the infeed by two-stage control using an infeed tension (Tu1) set based on a difference in circumferential speed between the can roll and the first infeed-side motor driven roll and an infeed tension (Tu2) (Tu1 > Tu2) set based on a difference in circumferential speed between the first infeed-side motor driven roll and the second infeed-side motor driven roll; and
adjusting a tension of the long substrate outfed from the can roll in the direction of the outfeed by two-stage control using an outfeed tension (Td1) set based on a difference in circumferential speed between the first outfeed-side motor driven roll and the can roll, and an outfeed tension (Td2) (Td1 > Td2) set based on a difference in circumferential speed between the second outfeed-side motor driven roll and the first outfeed-side motor driven roll.

The long substrate treatment apparatus and treatment method according to the present invention are
characterized in that
the tension of the long substrate infed toward the can roll in the direction of the infeed is adjusted by two-stage control using the infeed tension Tu1, which is set based on the difference in circumferential speed between the can roll and the first infeed-side motor driven roll, and the infeed tension Tu2 (Tu1 > Tu2),
which is set based on the difference in circumferential speed between the first infeed-side motor driven roll and the second infeed-side motor driven roll, and
the tension of the long substrate outfed from the can roll in the direction of the outfeed is adjusted by two-stage control using the outfeed tension Td1, which is set based on the difference in circumferential speed between the first outfeed-side motor driven roll and the can roll, and the outfeed tension (Td2) (Td1 > Td2), which is set based on the difference in circumferential speed between the second outfeed-side motor driven roll and the first outfeed-side motor driven roll.

Then, even in the case where a large difference is set between the tension of the long substrate transferred through the treatment zone, in which a thermal load is applied, and the tension of the long substrate transferred through a zone adjacent to the treatment zone, such as the drying zone or the winding zone, such a case can be handled by the two-stage control on the infeed tension and the outfeed tension in the treatment zone. It is therefore possible to solve the problem of formation of scratches or the like on the long substrate due to slippage of the long substrate on the surface of the can roll.

Further, the two-stage control on the infeed tension and the outfeed tension in the treatment zone makes it possible to set the gas pressure in the gap regions between the outer peripheral surface of the can roll and the long substrate at the wrapped portion region to an appropriate condition. This improves the thermal conductance (heat transfer efficiency) and makes it possible to solve the problem of formation of wrinkles or the like on the long substrate.

### BRIEF DESCRIPTION OF THE DRAWINGS

FIG. 1 is an explanatory diagram illustrating a schematic configuration of a long substrate treatment apparatus according a first embodiment of the present invention including an unwinding chamber, a drying chamber, a deposition chamber, and a winding chamber and further including a can roll with a gas discharge mechanism disposed in the deposition chamber, where sign "Tu1" denotes an infeed tension Tu1, sign "Tu2" denotes an infeed tension Tu2, sign "Td1" denotes an outfeed tension Td1, and sign "Td2" denotes an outfeed tension Td2.
FIG. 2 is an explanatory diagram illustrating a schematic configuration of a long substrate treatment apparatus according a second embodiment of the present invention including an unwinding chamber, a deposition chamber, and a winding chamber and further including a can roll with a gas discharge mechanism disposed in the deposition chamber.
FIG. 3 is a schematic perspective view of a fixed ring unit and a rotary ring unit each including a gas control sliding contact surface formed perpendicularly to the center axis of a can roll.
FIG. 4 is an explanatory diagram illustrating a schematic configuration of a can roll formed such that the gas control sliding contact surfaces of the fixed ring unit and the rotary ring unit can be perpendicular to the center axis of the can roll.
FIG. 5 is a side view, an A-A' cross-sectional view, and a B-B' cross-sectional view of a rotary joint including the fixed ring unit and the rotary ring unit each including a gas control sliding contact surface formed perpendicularly to the center axis of a can roll.
FIG. 6 is a schematic perspective view of a fixed ring unit and a rotary ring unit each including a gas control sliding contact surface formed in parallel to the center axis of the can roll.
FIG. 7 is an explanatory diagram illustrating a schematic configuration of a can roll formed such that the gas control sliding contact surfaces of the fixed ring unit and the rotary ring unit can be parallel to the center axis of the can roll.
FIG. 8 is a side view, an A-A' cross-sectional view, and a B-B' cross-sectional view of a rotary joint including the fixed ring unit and the rotary ring unit each including a gas control sliding contact surface formed in parallel to the center axis of the can roll.
FIG. 9 is a schematic perspective view of the can roll with a gas discharge mechanism according to Patent Document 7, equipped with a rotary joint.
FIG. 10 is an explanatory view illustrating a schematic configuration of a long substrate treatment apparatus according to a conventional example including an unwinding chamber, a drying chamber, a deposition chamber, and a winding chamber and further including a can roll with a gas discharge mechanism disposed in the deposition chamber, where sign "Tu1" denotes an infeed tension Tu1, sign "Td1" denotes an outfeed tension Td1, sign "N W P" denotes non-wrapped portion, and sign "W P" denotes wrapped portion.

### DESCRIPTION OF THE PREFERRED EMBODIMENTS

Long substance treatment apparatuses according to embodiments of the present invention and a long substance treatment apparatus according to a conventional example are described below in detail by using the drawings.

### [Long Substance Treatment Apparatus According to Conventional Example]

(1) First, the long substance treatment apparatus according to the conventional example is described with reference to FIG. 10.

Note that the description is given by taking a long heat-resistant resin film (abbreviated as the long film) as an example of the long substrate and taking a sputtering process as an example of the treatment that applies a thermal load.

Also, in FIG. 10, motor driven rolls (including an unwinding roll 215, a can roll 231, and a winding roll 246) are denoted by reference sign M (motor), tension measurement rolls are denoted by reference sign TP (tension pick up), and free rolls are denoted by reference sign F (free). Further, a long film 214 unwound from the unwinding roll 215 is illustrated using two ways of unwinding with a solid line and a chain line, and the long film 214 wound around the winding roll 246 is also illustrated using two ways with a solid line and a chain line, as mentioned above.

As illustrated in FIG. 10, this treatment apparatus includes an unwinding chamber 210, a drying chamber 211, a deposition chamber 212, and a winding chamber 213. Note that a surface activation treatment chamber that performs plasma irradiation or ion beam irradiation to improve the bond between the long film and a metal film is provided in some cases between the drying chamber 211 and the deposition chamber 212.

### (Unwinding Chamber)

In the unwinding chamber 210, the long film 214 before deposition is transferred from the unwinding roll 215 to the drying chamber 211 through a free roll 216, a tension measurement roll 217, and a free roll 218. Note that the unwinding tension of the long film 214 (a tension based on the difference in circumferential speed between the unwinding roll 215 and a motor driven roll 219 in the drying chamber 211) is measured by the tension measurement roll 217 and fed back to and controlled by the unwinding roll 215, as mentioned above.

### (Drying Chamber)

In the drying chamber 211, heater units 224 are disposed, and the long film 214 is transferred to the deposition chamber 212 through the motor driven roll 219, a free roll 220, a tension measurement roll 221, a free roll 222, and a free roll 223. Note that the drying tension of the long film 214 (a tension based on the difference in circumferential speed between the motor driven roll 219 and an infeed-side motor driven roll 229 in the deposition chamber 212) is measured by the tension measurement roll 221 and fed back to and controlled by the motor driven roll 219, as mentioned above.

### (Deposition chamber)

Also, in the deposition chamber 212, sputtering cathodes 239, 240, 241, and 242 are disposed, and the long film 214 is transferred to the winding chamber 213 through the infeed-side motor driven roll 229, an infeed-side tension measurement roll 230, the can roll 231, an outfeed-side tension measurement roll 232, and an outfeed-side motor driven roll 233. Note that an infeed tension Tu1 of the long film 214 infed toward the can roll 231 (a tension based on the difference in circumferential speed between the infeed-side motor driven roll 229 and the can roll 231) is measured by the infeed-side tension measurement roll 230 and fed back to and controlled by the infeed-side motor driven roll 229, and an outfeed tension Td1 of the long film 214 outfed from the can roll 231 (a tension based on the difference in circumferential speed between the can roll 231 and the outfeed-side motor driven roll 233) is measured by the outfeed-side tension measurement roll 232 and fed back to and controlled by the outfeed-side motor driven roll 233, as mentioned above.

### (Winding Chamber)

In the winding chamber 213, the long film 214 is wound up around the winding roll 246 through a free roll 243, a tension measurement roll 244, and a free roll 245. Note that the winding tension of the long film 214 (a tension based on the difference in circumferential speed between the outfeed-side motor driven roll 233 and the winding roll 246) is measured by the tension measurement roll 244 and fed back to and controlled by the winding roll 246, as mentioned above.

Further, the vacuum chambers in the unwinding chamber 210, the drying chamber 211, the deposition chamber 212, and the winding chamber 213 each include evacuation equipment. In particular, in the deposition chamber 212, to perform sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. The shape and material of each vacuum chamber are not particularly limited but various shapes and materials are usable as long as they can withstand the above depressurized state. Each vacuum chamber includes apparatuses not illustrated such as dry pumps, turbomolecular pumps, and cryocoils to depressurize the inside of the vacuum chamber and maintain that state.

The treatment apparatus illustrated in FIG. 10 has a structure in which the zones of the unwinding chamber 210, the drying chamber 211, the deposition chamber 212, and the winding chamber 213 are provided in respective individual chambers (vacuum chambers). Note, however, that there are also treatment apparatuses with a structure in which an unwinding zone, a drying zone, a deposition zone, and a winding zone are provided in a single chamber (vacuum chamber), as mentioned above.

### (2) Problem with Treatment Apparatus According to Conventional Example

As mentioned above, the tension of the long film 214 transferred through the zones of the unwinding chamber 210, the drying chamber 211, the deposition chamber 212, and the winding chamber 213 is set differently from one zone to another. There are cases where the drying tension of the long film 214 transferred through the drying chamber 211 is set to 30 N (newton) and the infeed tension and outfeed tension of the long film 214 transferred through the deposition chamber 212 are set to 200 N. This large tension difference is controlled by the motor driven rolls, the motor driven can roll, and so on. However, with the large tension difference, the problem is that it is difficult to control that tension difference with the motor driven rolls, the can roll, and so on, which causes slippage, vibration, or the like of the long film 214 on the surface of the can roll 231, thereby making the tension unstable and forming scratches or the like on the long film 214.

### [Long Substrate Treatment Apparatuses According to Embodiments of Present Invention]

(1) The long substrate treatment apparatuses according to the embodiments are described with reference to FIGS. 1 and 2.

Note that the description is given by taking a long heat-resistant resin film (abbreviated as the long film) as an example of the long substrate and taking a sputtering process as an example of the treatment that applies a thermal load.

Also, in FIGS. 1 and 2, motor driven rolls (including an unwinding roll 115, a can roll 131, and a winding roll 146) are denoted by reference sign M (motor), tension measurement rolls are denoted by reference sign TP (tension pick up), and free rolls are denoted by reference sign F (free). Further, a long film 114 unwound from the unwinding roll 115 is illustrated using two ways of unwinding with a solid line and a chain line, and the long film 114 wound around the winding roll 146 is also illustrated using two ways with a solid line and a chain line.

Firstly, as illustrated in FIG. 1, a treatment apparatus according to a first embodiment includes an unwinding chamber 110, a drying chamber 111, a deposition chamber 112, and a winding chamber 113. As illustrated in FIG. 2, a treatment apparatus according to a second embodiment includes an unwinding chamber 110, a deposition chamber 112, and a winding chamber 113 without the above-mentioned drying chamber 111. Note that in the treatment apparatus according to the first embodiment, a surface activation treatment chamber that performs plasma irradiation or ion beam irradiation to improve the bond between the long film and a metal film is provided in some cases between the drying chamber 111 and the deposition chamber 112.

### (Unwinding Chamber)

In the unwinding chamber 110, the long film 114 before deposition is transferred from the unwinding roll 115 to the drying chamber 111 through a free roll 116, a tension measurement roll 117, and a free roll 118. Note that the unwinding tension of the long film 114 (a tension based on the difference in circumferential speed between the unwinding roll 115 and a motor driven roll 119 in the drying chamber 111) is measured by the tension measurement roll 117 and fed back to and controlled by the unwinding roll 115, similarly to the apparatus according to the conventional example.

### (Drying Chamber)

In the drying chamber 111, heater units 124 are disposed, and the long film 114 is transferred to the deposition chamber 112 through the motor driven roll 119, a free roll 120, a tension measurement roll 121, a free roll 122, and a free roll 123. Note that the drying tension of the long film 114 (a tension based on the difference in circumferential speed between the motor driven roll 119 and a second infeed-side motor driven roll 125 in the deposition chamber 112) is measured by the tension measurement roll 121 and fed back to and controlled by the motor driven roll 119.

### (Deposition Chamber)

In the deposition chamber 112, sputtering cathodes 139, 140, 141, and 142 are disposed, and the long film 114 is transferred to the winding chamber 113 through the second infeed-side motor driven roll 125, a free roll 126, a second infeed-side tension measurement roll 127, a free roll 128, a first infeed-side motor driven roll 129, a first infeed-side tension measurement roll 130, the can roll 131, a first outfeed-side tension measurement roll 132, a first outfeed-side motor driven roll 133, a free roll 134, a second outfeed-side tension measurement roll 135, a free roll 136, and a second outfeed-side motor driven roll 137.

Also, the first infeed-side tension measurement roll 130 and the first infeed-side motor driven roll 129 form a "first infeed-side tension control roll group", and the second infeed-side tension measurement roll 127 and the second infeed-side motor driven roll 125 form a "second infeed-side tension control roll group". Moreover, the first outfeed-side tension measurement roll 132 and the first outfeed-side motor driven roll 133 form a "first outfeed-side tension control roll group", and the second outfeed-side tension measurement roll 135 and the second outfeed-side motor driven roll 137 form a "second outfeed-side tension control roll group".

Further, an infeed tension Tu1 of the long film 114 (a tension based on the difference in circumferential speed between the first infeed-side motor driven roll 129 and the can roll 131) is measured by the first infeed-side tension measurement roll 130 and fed back to and controlled by the first infeed-side motor driven roll 129. Moreover, an infeed tension Tu2 of the long film 114 (a tension based on the difference in circumferential speed between the first infeed-side motor driven roll 129 and the second infeed-side motor driven roll 125) is measured by the second infeed-side tension measurement roll 127 and fed back to and controlled by the second infeed-side motor driven roll 125. On the other hand, an outfeed tension Td1 of the long film 114 (a tension based on the difference in circumferential speed between the first outfeed-side motor driven roll 133 and the can roll 131) is measured by the first outfeed-side tension measurement roll 132 and fed back to and controlled by the first outfeed-side motor driven roll 133. Moreover, an outfeed tension Td2 of the long film 114 (a tension based on the difference in circumferential speed between the first outfeed-side motor driven roll 133 and the second outfeed-side motor driven roll 137) is measured by the second outfeed-side tension measurement roll 135 and fed back to and controlled by the second outfeed-side motor driven roll 137.

### (Winding Chamber)

In the winding chamber 113, the long film 114 is wound up around the winding roll 146 through a free roll 143, a tension measurement roll 144, and a free roll 145. Note that the winding tension of the long film 114 (a tension based on the difference in circumferential speed between the second outfeed-side motor driven roll 137 and the winding roll 146) is measured by the tension measurement roll 144 and fed back to and controlled by the winding roll 146.

Further, vacuum chambers in the unwinding chamber 110, the drying chamber 111, the deposition chamber 112, and the winding chamber 113 each include evacuation equipment, similarly to the treatment apparatus according to the conventional example (see FIG. 10). In particular, in the deposition chamber 112, to perform sputtering deposition, the pressure is lowered to about an ultimate pressure of 10⁻⁴ Pa and thereafter the pressure is adjusted to about 0.1 to 10 Pa via introduction of a sputtering gas. A publicly known gas such as argon is used as the sputtering gas and, depending on the purpose, a gas such as oxygen is further added. Also, the shape and material of each vacuum chamber are not particularly limited but various shapes and materials are usable as long as they can withstand the above depressurized state. Each vacuum chamber includes apparatuses not illustrated such as dry pumps, turbomolecular pumps, and cryocoils to depressurize the inside of the vacuum chamber and maintain that state.

Meanwhile, for sputtering deposition of a metal film, plate-shaped targets can be used, as illustrated in FIG. 1. However, in the case of using plate-shaped targets, generation of nodules (growth of foreign matter) may occur on the targets in some cases. If this is problematic, it is preferable to use cylindrical rotary targets, which are free from the generation of nodules and also have high target use efficiency. Also, since the treatment apparatus in FIG. 1 is assumed to perform a sputtering process as the treatment that applies a thermal load, magnetron sputtering cathodes are illustrated. However, in a case where the treatment that applies a thermal load is a different treatment such that CVD (chemical vapor deposition) or a vapor deposition process, different vacuum deposition means is provided in place of the plate-shaped targets.

### (2) Advantageous Effects of Long Substrate Treatment Apparatuses According to Embodiments

The treatment apparatuses according to the first embodiment and the second embodiment are characterized in that the tension of the long film 114 infed toward the can roll 131 in the direction of the infeed is adjusted by two-stage control using the infeed tension Tu1, which is set based on the difference in circumferential speed between the first infeed-side motor driven roll 129 and the can roll 131, and the infeed tension Tu2 (Tu1 > Tu2), which is set based on the difference in circumferential speed between the first infeed-side motor driven roll 129 and the second infeed-side motor driven roll 125, and
the tension of the long film 114 outfed from the can roll 131 in the direction of the outfeed is adjusted by two-stage control using the outfeed tension Td1, which is set based on the difference in circumferential speed between the first outfeed-side motor driven roll 133 and the can roll 131, and the outfeed tension Td2 (Td1 > Td2), which is set based on the difference in circumferential speed between the first outfeed-side motor driven roll 133 and the second outfeed-side motor driven roll 137.

Then, even in the case where a large difference is set between the tension of the long film 114 transferred through the deposition chamber (treatment zone) 112, in which a thermal load is applied, and the tension of the long film 114 transferred through a chamber adjacent to the deposition chamber (treatment zone) 112, such as the drying chamber (drying zone) 111, the unwinding chamber (unwinding zone) 110, or the winding chamber (winding zone) 113, such a case can be handled by the two-stage control on an infeed tension Tu and an outfeed tension Td in the deposition chamber (treatment zone) 112. It is therefore possible to solve the problem of formation of scratches or the like on the long film 114 due to slippage of the long film 114 on the surface of the can roll 131.

Further, the two-stage control on the infeed tension Tu and the outfeed tension Td in the deposition chamber (treatment zone) 112 makes it possible to set the gas pressure in the gap regions between the outer peripheral surface of the can roll 131 and the long film 114 at the wrapped portion region to an appropriate condition. This improves the thermal conductance (heat transfer efficiency) and makes it possible to solve the problem of formation of wrinkles or the like on the long film 114.

### [Can Roll with Gas Discharge Mechanism]

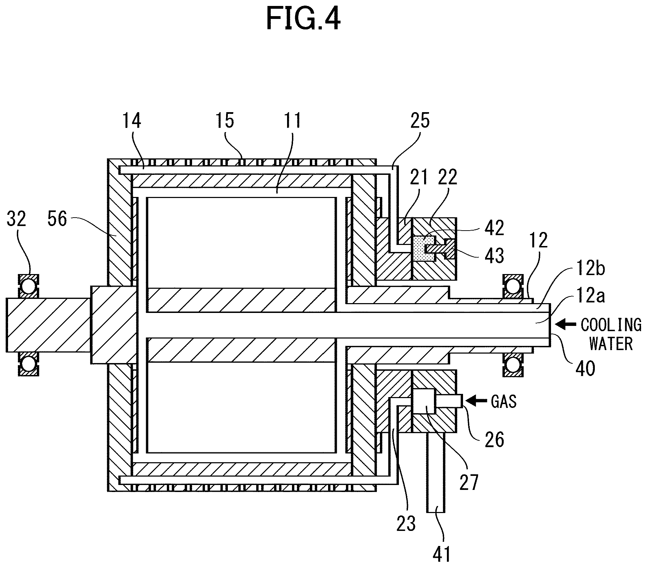

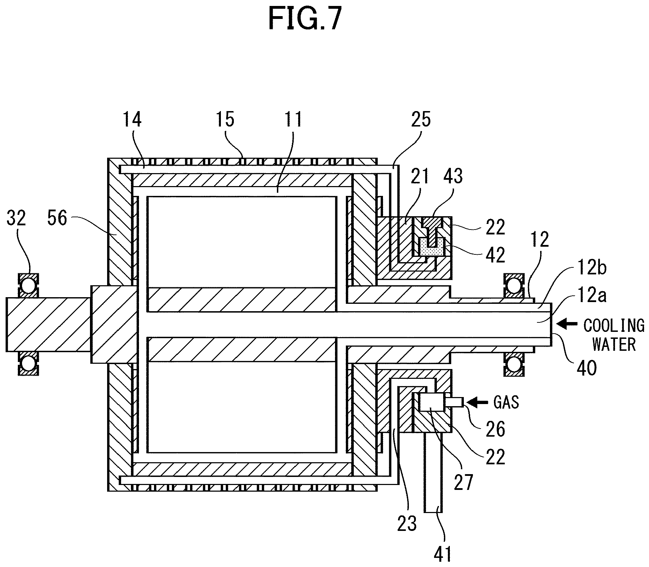

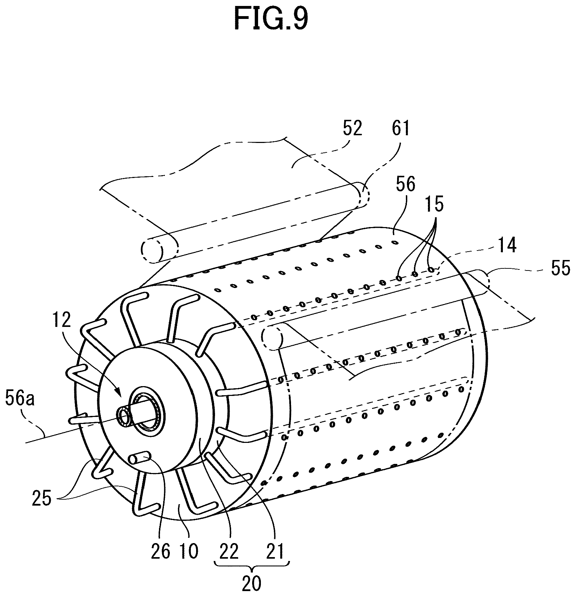

Next, a can roll with a gas discharge mechanism is described with reference to FIGS. 4, 7, and 9. A can roll 56 with a gas discharge mechanism includes a cylindrical member 10 that is rotationally driven about a center axis 56a by a drive apparatus not illustrated (see FIG. 9). On the outer surface of this cylindrical member 10, a transfer path is defined along which to wrap and transfer a long heat-resistant resin film (long substrate) 52. On the inner surface side of the cylindrical member 10, a coolant circulation portion 11 (see FIGS. 4 and 7) with a jacket structure is formed through which a coolant such as cooling water flows.

Also, a rotary shaft 12 (see FIG. 9) situated at the position of the center axis 56a of the cylindrical member 10 has a double-pipe structure, and the coolant circulates between a coolant cooling apparatus not illustrated which is provided outside the vacuum chamber and the coolant circulation portion 11 through this rotary shaft 12. This makes it possible to adjust the temperature of the outer peripheral surface of the can roll 56.

Specifically, the coolant, such as cooling water, cooled by the coolant cooling apparatus is introduced from a cooling water inlet 40 and sent through an inner pipe 12a to the coolant circulation portion 11, at which the coolant receives the heat of the long substrate 52, thereby rising in temperature. Thereafter, the coolant is returned again to the coolant cooling apparatus through a space between the inner pipe 12a and an outer pipe 12b. Note that bearings 32 that support the rotating can roll 56 are provided on the outer side of the outer pipe 12b.

A plurality of gas introduction channels 14 are arranged over the entire circumference of the cylindrical member 10 of this can roll 56 at substantially equal intervals in the circumferential direction. The plurality of gas introduction channels 14 are each bored in a thick portion of the cylindrical member 10 so as to extend along the direction of the center axis 56a of the can roll 56. Note that FIG. 9 illustrates an example where 12 gas introduction channels 14 are arranged over the entire circumference at equal intervals.

Each gas introduction channel 14 includes a plurality of gas discharge holes 15 opening toward the outer surface of the cylindrical member 10 (i.e. the outer peripheral surface of the can roll 56). The plurality of gas discharge holes 15 are bored at substantially equal intervals along the direction of the center axis 56a of the can roll 56. Moreover, as illustrated in FIG. 9, a gas is supplied from outside the vacuum chamber into each gas introduction channel 14 through a rotary joint 20 including a rotary ring unit 21 and a fixed ring unit 22. In this way, the gas can be introduced into the gap regions (clearances) formed between the outer peripheral surface of the can roll 56 and the long substrate 52 wrapped thereon.

As mentioned above, the long substrate 52 and the surface of the can roll 56 are not completely flat surfaces. Then, with a vacuum therein, the gap regions (clearances) are thermally insulated by the vacuum and accordingly lower the thermal conductivity. This causes the formation of wrinkles on the long substrate 52 by the heat during the sputtering deposition.

Note that, as mentioned above, according to Non-Patent Document 2, in a case where the introduced gas is an argon gas and the pressure of the introduced gas is 500 Pa, then, when the gap regions (clearances) between the outer peripheral surface of a can roll and a film wrapped on the outer peripheral surface of the can roll are molecular flow regions measuring approximately 40 µm or shorter in distance, the thermal conductance of the gap regions is 250 (W/m²·K). For the above-described can roll with a gas discharge mechanism too, the higher the gas pressure in the gaps between the surface of the can roll and the film at the wrapped portion, the higher the heat transfer efficiency and the higher the film cooling efficiency. However, if the gas pressure is higher than a reaction P = T/R (R: the radius of the can roll) which is a force with which the film is pressed against the can roll under its tension T, the film floats from the can roll, which makes it difficult to control the gas pressure, as mentioned above. It is therefore important to control the gas pressure in the gaps between the surface of the can roll and the film.

Description is given below of a "perpendicular rotary joint" in which gas control sliding contact surfaces of its rotary ring unit and fixed ring unit are formed perpendicularly to the center axis of a can roll, and a "parallel rotary joint" in which gas control sliding contact surfaces of its rotary ring unit and fixed ring unit are formed in parallel to the center axis of a can roll.

### [Rotary Joint]

### (1) Perpendicular Rotary Joint

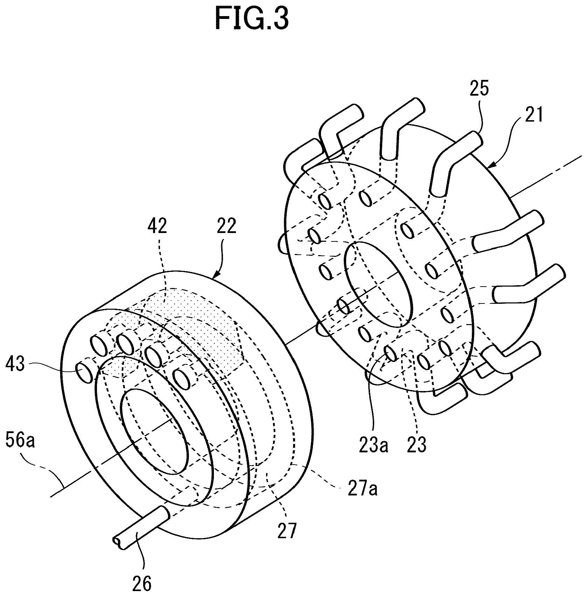

As illustrated in FIGS. 3 to 5, the perpendicular rotary joint includes a rotary ring unit 21 and a fixed ring unit 22 fixed by a fixing member 41 so as not to rotate.

Further, the rotary ring unit 21 includes a plurality of gas supply channels 23 that communicate with the plurality of gas introduction channels 14 through connection pipes 25, respectively. Moreover, each gas supply channel 23 includes a revolving opening portion 23a at the gas control sliding contact surface, the revolving opening portion 23a opening at an angular position corresponding to the angular position, on the outer peripheral surface of the can roll 56, of the gas introduction channel 14 communicating with the gas supply channel 23 through the corresponding connection pipe 25 (substantially the same angular position as the angular position on the outer peripheral surface of the can roll 56).

On the other hand, the fixed ring unit 22 includes a gas distribution channel 27 formed by an annular recessed groove 27a, including a fixed closed portion and a fixed opening portion, and communicating with a supply pipe 26 outside the vacuum chamber, the annular recessed groove 27a being provided in the gas control sliding contact surface so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. Also, the fixed opening portion opens within an angular range in the region on the gas control sliding contact surface of the fixed ring unit 22 which the revolving opening portions 23a of the rotary ring unit 21 face, the angular range being a range within which the long heat-resistant resin film (long substrate) 52 is wrapped.

Further, as illustrated in FIG. 3, at the non-wrapped portion region of the outer peripheral surface of the can roll 56, at which the long substrate 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber is not supplied to the gas supply channels 23. Hence, the gas is not discharged from the gas discharge holes 15 in the outer peripheral surface of the can roll 56.

On the other hand, as illustrated in FIG. 3, at the wrapped portion region of the outer peripheral surface of the can roll 56, at which the long substrate 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

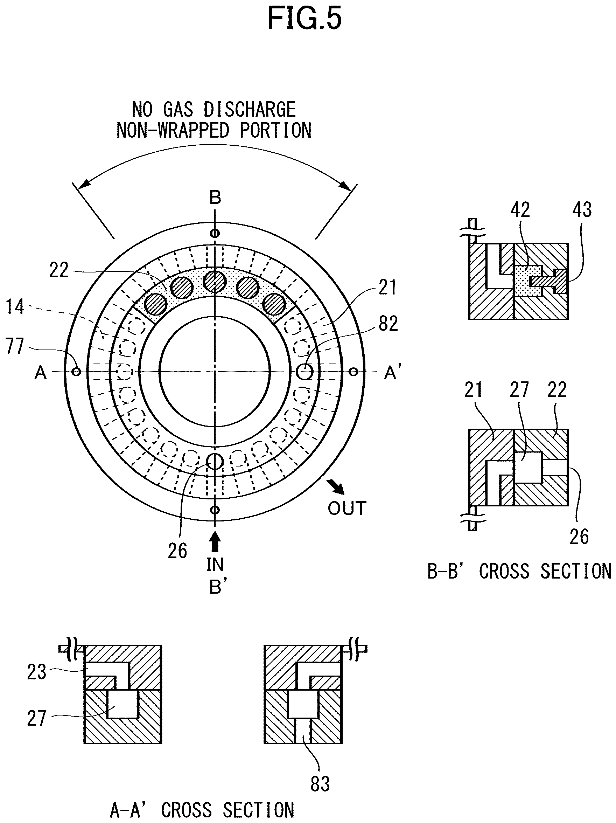

Meanwhile, reference sign 43 in FIGS. 3 to 5 denote a packing attachment member, and reference sign 77 in FIG. 5 denotes a fixing screw hole in the rotary ring unit 21. Also, reference signs 82 and 83 in FIG. 5 denote a pressure gauge port for measuring the pressure in the gas distribution channel 27, which is equal to the gas pressure in the gaps between the outer peripheral surface of the can roll 56 and the long substrate 52 at the wrapped portion region of the surface of the can roll 56, at which the long substrate 52 is wrapped.

### (2) Parallel Rotary Joint

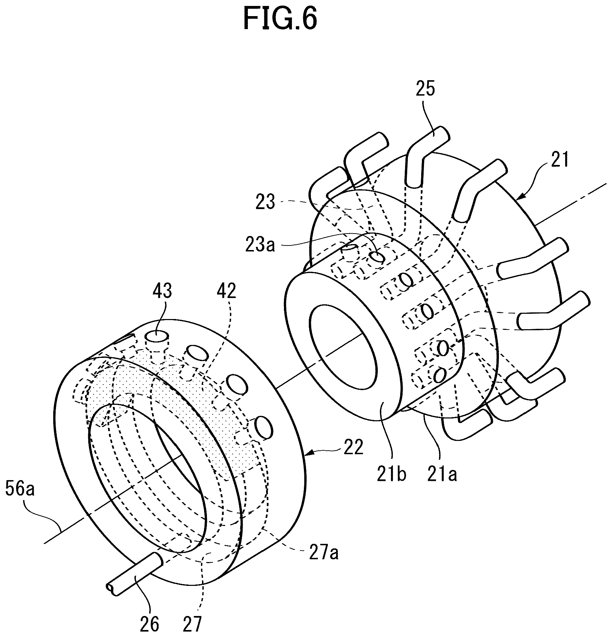

As illustrated in FIGS. 6 to 8, the parallel rotary joint includes a rotary ring unit 21 which has a T-shaped cross section and includes a cylindrical base part 21a and a cylindrical protruding part 21b, and a fixed ring unit 22 in which the cylindrical protruding part 21b of the rotary ring unit 21 is fitted and which is fixed by a fixing member 41 so as not to rotate.

Further, the rotary ring unit 21 includes a plurality of gas supply channels 23 that communicate with the plurality of gas introduction channels 14 through connection pipes 25, respectively. Moreover, each gas supply channel 23 includes a revolving opening portion 23a at the gas control sliding contact surface of the cylindrical protruding part 21b, the revolving opening portion 23a opening at an angular position corresponding to the angular position, on the outer peripheral surface of the can roll 56, of the gas introduction channel 14 communicating with the gas supply channel 23.

On the other hand, the fixed ring unit 22 includes a gas distribution channel 27 formed by an annular recessed groove 27a, including a fixed closed portion and a fixed opening portion, and communicating with a supply pipe 26 outside the vacuum chamber, the annular recessed groove 27a being provided in the cylindrical inner peripheral surface of the fixed ring unit 22 so as to extend in the circumferential direction, the fixed closed portion being a portion at which the gas control sliding contact surface of the fixed ring unit 22 is closed by an arched packing member 42 fitted in a predetermined region inside the annular recessed groove 27a, the fixed opening portion being a portion at which the gas control sliding contact surface is not closed. Also, the fixed opening portion opens within an angular range in the region on the gas control sliding contact surface of the fixed ring unit 22 which the revolving opening portions 23a of the cylindrical protruding part 21b of the rotary ring unit 21 face, the angular range being a range within which the long substrate 52 is wrapped.

Further, as illustrated in FIG. 6, at the non-wrapped portion region of the outer peripheral surface of the can roll 56, at which the long substrate 52 is not wrapped, the structure is such that the revolving opening portions 23a of the rotary ring unit 21 face the fixed closed portion of the annular recessed groove 27a of the fixed ring unit 22, in which the arched packing member 42 is fitted, so that the gas supply channels 23 and the gas distribution channel 27 are disconnected from each other and the gas from outside the vacuum chamber is not supplied to the gas supply channels 23. Hence, the gas is not discharged from the gas discharge holes 15 in the outer peripheral surface of the can roll 56.

On the other hand, as illustrated in FIG. 6, at the wrapped portion region of the outer peripheral surface of the can roll 56, at which the long substrate 52 is wrapped, the revolving opening portions 23a of the rotary ring unit 21 face the fixed opening portion of the annular recessed groove 27a of the fixed ring unit 22, in which the arched packing member 42 is not fitted, so that the gas supply channels 23 and the gas distribution channel 27 are connected to each other. Hence, the gas is discharged from the gas discharge holes 15 in the outer peripheral surface of the can roll 56, and the gas is introduced into the gap regions between the outer peripheral surface of the can roll 56 and the film 52.

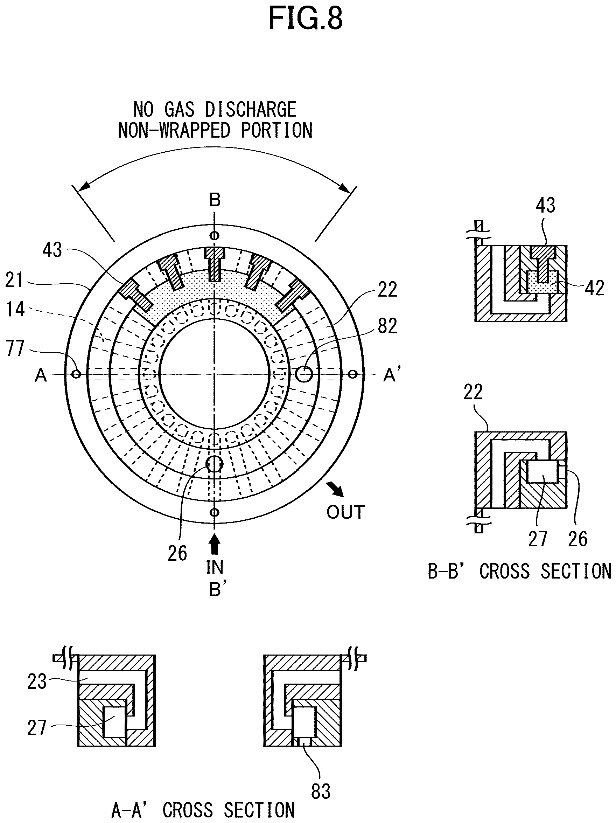

Meanwhile, reference sign 43 in FIGS. 6 to 8 denote a packing attachment member, and reference sign 77 in FIG. 8 denotes a fixing screw hole in the rotary ring unit 21. Also, reference signs 82 and 83 in FIG. 8 denote a pressure gauge port for measuring the pressure in the gas distribution channel 27, which is equal to the gas pressure in the gaps between the outer peripheral surface of the can roll 56 and the long substrate 52 at the wrapped portion region of the surface of the can roll 56, at which the long substrate 52 is wrapped.

### [Long Substrate and Process That Applies Thermal Load]

The treatment apparatus according to the present invention has been described by taking a heat-resistant resin film as an example of the long substrate. However, other resin films, as a matter of course, and also metal films such as metal foils and metal strips are also usable as the long substrate used in the long substrate treatment apparatus according to the present invention. Examples of the resin films may include resin films with relatively poor heat resistance such as a polyethylene terephthalate (PET) film and heat-resistant resin films such as a polyimide film.

In the case of fabricating the metal film-coated heat-resistant resin film mentioned above, a heat-resistant resin film selected from among a polyimide-based film, a polyamide-based film, a polyester-based film, a polytetrafluoroethylene-based film, a polyphenylene sulfide-based film, a polyethylene naphthalate-based film, and a liquid-crystal polymer-based film is preferably used. This is because a metal film-coated heat-resistant resin film obtained using any of these is superior in flexibility required for metal film-coated flexible substrates, strength necessary to practical use, and electrical insulation performance preferable as a wiring material.

Also, a metal film-coated heat-resistant resin film can be manufactured by using the above heat-resistant resin film as the long substrate and performing sputtering deposition of metal films on the surface of the heat-resistant resin film. For example, by processing the heat-resistant resin film by a metallizing method using the above deposition apparatus (sputtering web coater), a long metal film-coated heat-resistant resin film can be obtained which is the heat-resistant resin film with a film made of an Ni-based alloy or the like and a Cu film laminated on the surface of the heat-resistant resin film.

After the deposition process, the above metal film-coated heat-resistant resin film is sent to a further process, in which the metal film-coated heat-resistant resin film is processed by a subtractive method into a flexible wiring substrate including a predetermined wiring pattern. Here, the subtractive method refers to a method of manufacturing a flexible wiring substrate by removing a metal film not covered by a resist (e.g. the above Cu film) by etching.

The above film made of an Ni-based alloy or the like is called a seed layer, and its composition is selected as appropriate based on properties required for the metal film-coated heat-resistant resin film such as electric insulation performance and migration resistance. Generally, however, it is made of a publicly known alloy such as an Ni-Cr alloy, Inconel, constantan, or Monel. Note that a wet plating method is sometimes used in a case where a metal film (Cu film) of the metal film-coated heat-resistant resin film is desired to be thicker. In this case, used is a method in which the metal film is formed by only an electroplating process or a method in which a combination of wet plating processes such as an electroless plating process as primary plating and an electrolytic plating process as secondary plating. For the above wet plating processes, general wet plating conditions can be employed.

Note that the description has been given by taking, as an example, a metal film-coated heat-resistant resin film obtained by laminating films of metals such as an Ni-Cr alloy and Cu on a long heat-resistant resin film. However, it is also possible to use the present invention to form films other than the above metal films such as oxide films, nitride films, and carbide films in accordance with the purpose.

Also, the long substrate treatment apparatus according to the present invention has been described by taking a vacuum deposition apparatus as an example. However, the above treatment apparatus also covers treatments that apply a thermal load such as plasma treatment and ion beam treatment, besides vacuum deposition such as sputtering performed on a long substrate inside a vacuum chamber under a depressurized atmosphere. While these plasma treatment and ion beam treatment modify the surface of a long substrate, these apply a thermal load to the long substrate. The treatment apparatus according to the present invention is applicable to these cases and can prevent formation of wrinkles on the long substrate due to the thermal load without leaking a large amount of the introduced gas. Examples of the plasma treatment include a method in which a long substrate is processed with an oxygen plasma or nitrogen plasma generated via discharge through a mixed gas of argon and oxygen or a mixed gas of argon and nitrogen under a depressurized atmosphere. Also, the ion beam treatment refers to a treatment in which a plasma discharge is generated in a magnetic field gap where a strong magnetic field is applied, and positive ions in the plasma as an ion beam to a long substrate. Note that a publicly known ion beam source can be used in the ion beam treatment. Also, these plasma treatment and ion beam treatment are both performed under a depressurized atmosphere.

### [Examples]

Examples 1 and 2 and reference examples 1 to 7 using the deposition apparatus (sputtering web coater) according to the present invention illustrated in FIG. 1, and comparative examples 1 to 5 using the deposition apparatus (sputtering web coater) according to the conventional example illustrated in FIG. 10 are specifically described below.

### [Design of Parallel Rotary Joint]

First, the parallel rotary joint illustrated in FIGS. 6 to 8 was designed.

The diameter of the rotary joint (rotary ring unit 21 and fixed ring unit 22) was set to approximately 400 mm, and the number of connection pipes (gas introduction pipes) 25 on the rotary ring unit 21, connected to (communicating with) the gas introduction channels 14 of the can roll 56, was set to 36. Thus, gas control at angular intervals of 10° (360°/36 = 10°) was possible.

Also, the first infeed-side tension measurement roll 130 illustrated in FIG. 1, disposed near the infeed-side of the can roll 131, was set such that the can roll 131 and the long film 114 contacted each other at a 20° angle position. The first outfeed-side tension measurement roll 132, provided near the outfeed side of the can roll 131, was set such that the can roll 131 and the long film 114 contacted each other at a 340° angle position (in other words, the angle across the non-wrapped portion was set to 40°). Note that an angle of 20° was set on both sides of the angular range of the non-wrapped portion as a range where gas control could be unstable, and the gas stop angle for the non-wrapped portion (the angle of the fixed closed portion formed by the arched packing member 42 fitted in a predetermined region inside the annular recessed groove 27a forming the gas distribution channel 27 of the fixed ring unit 22) was set to 90° (> 40° (the non-wrapped portion) + 20° × 2 (the unstable portions on both sides)). In other words, the arched packing member 42, disposed in the gas distribution channel 27, needs a function to close at most nine gas introduction channels 14, which corresponds to 90°.

### [Examples 1 and 2 and Reference Examples 1 to 7]

Long metal film-coated heat-resistant resin films were fabricated using the deposition apparatus (sputtering web coater) according to the present invention illustrated in FIG. 1. As the long heat-resistant resin film (hereinafter, referred to as the film 114), a heat-resistant polyimide film "UPILEX (registered trademark)", manufactured by Ube Industries, Ltd, measuring 500 mm in width, 800 m in length, and 25 µm in thickness was used.

As the can roll 131, a can roll with a gas introduction mechanism having a jacket roll structure as illustrated in FIG. 9 was used. As the cylindrical member 10 (see FIG. 9) of this can roll 131, a stainless cylindrical member measuring 800 mm in diameter and 800 mm in width was used, and hard chromium plating was performed on its outer peripheral surface. 180 gas introduction channels 14 were bored over the entire circumference of a thick portion of this cylindrical member 10 at equal intervals in the circumferential direction, the gas introduction channels 14 measuring 5 mm in inner diameter and extending in parallel to the direction of the rotation axis of the can roll 131. Note that, of the two ends of each gas introduction channel 14, the distal end was formed into a closed bottom so as not to penetrate through the cylindrical member 10.

Each gas introduction channel 14 was provided with 47 gas discharge holes 15 measuring 0.2 mm in inner diameter and opening toward the outer surface of the cylindrical member 10 (i.e. the outer peripheral surface of the can roll 131). These 47 gas discharge holes 15 were arranged at 10-mm intervals in a direction perpendicular to the direction of advance of the film 114 within a region between lines situated 20 mm inward from both sides of the transfer path of the film 114 defined on the outer surface of the cylindrical member 10. Specifically, the gas discharge holes 15 were not provided within 145-mm regions from both sides of the outer peripheral surface of the can roll 131.

As described above, 180 gas introduction channels 14 were arranged over the entire circumference of the cylindrical member 10 at equal intervals in the circumferential direction. It is difficult to directly connect these 180 gas introduction channels 14 to the rotary joint 20. For this reason, sets of five gas introduction channels 14 were connected to branched pipes (not illustrated) and then connected to the ends of the connection pipes 25 on the rotary ring unit 21. Specifically, on the rotary ring unit 21 of the rotary joint 20, 36 connection pipes 25 were formed, as mentioned above, through each of which the gas was introduced collectively for 10°.

As for the metal films formed on the film 114, a Cu film was formed on an Ni-Cr film, which was a seed layer. To do so, an Ni-Cr target was used as the magnetron sputter target 139, and Cu targets were used as the magnetron sputter targets 140, 141, and 142.

The film 114 in a rolled up state was set on the unwinding roll 115 of the above deposition apparatus (sputtering web coater), and one end of the film 114 was attached to the winding roll 146 through the can roll 131. In this state, the air in the vacuum chamber in the deposition chamber 112 was evacuated to 5 Pa by using a plurality of dry pumps and evacuated further to 3 × 10⁻³ Pa by using a plurality of turbomolecular pumps and cryocoils.

Subsequently, a rotational drive apparatus was actuated to transfer the long film 114 at a transfer speed of 8 m/min while an argon gas was introduced at 300 sccm and also electric power control was performed to apply an electric power of 20 kW to the magnetron sputter cathodes 139, 140, 141, and 142. Further, with a diaphragm gauge attached to the pressure gauge port 82, 83 (see FIG. 8) in the rotary joint mounted to the can roll 131, the flow rate of the argon gas from the supply pipe 26 of the fixed ring unit 22 was controlled such that the set gas pressure in the gaps between the surface of the can roll and the film could be at the value (450 to 1350 Pa) listed in table 1-3 below.

A treatment of continuously forming a seed layer made of an Ni-Cr film and a Cu film to be formed on the seed layer was started under the above conditions on one surface of the film 114 transferred in a roll-to-roll manner.

Tables 1-1 to 1-3 below list the "Unwinding Tension" (measured by the tension measurement roll 117 illustrated in FIG. 1), the "Drying Tension" (measured by the tension measurement roll 121), the "Infeed Tension Tu2" (measured by the second infeed-side tension measurement roll 127), the "Infeed Tension Tu1" (measured by the first infeed-side tension measurement roll 130), the "Outfeed Tension Td1"(measured by the first outfeed-side tension measurement roll 132), the "Outfeed Tension Td2"(measured by the second outfeed-side tension measurement roll 135), and the "Winding Tension" (measured by the tension measurement roll 144) in examples 1 and 2 and reference examples 1 to 7.

Note that the "Infeed Tension Tu2" in reference examples 5 to 7 and examples 1 and 2 is set to a value between the adjacent "Drying Tension" and "Infeed Tension Tu1", and the "Outfeed Tension Td2" in reference examples 6 and 7 and examples 1 and 2 is also set to a value between the adjacent "Outfeed Tension Td1" and "Winding Tension". On the other hand, the "Infeed Tension Tu2" and the "Outfeed Tension Td2" in reference examples 1 and 2 are set to be equal to the adjacent "Infeed Tension Tu1" and "Outfeed Tension Td1", respectively, the "Infeed Tension Tu2" in reference examples 3 and 4 is set to be equal to the adjacent "Drying Tension", and the "Outfeed Tension Td2" in reference examples 3 to 5 is also set to be equal to the adjacent "Winding Tension".

In addition, a "Reaction Pa" (the force with which the long film 114 is pressed against the can roll 131) and a "Set Gas Pressure Pa in Gaps" (equal to 90% of the reaction Pa) in examples 1 and 2 and reference examples 1 to 7, which are determined depending on the setting of the "Infeed Tension Tu1" and the "Outfeed Tension Td1", are listed as well.

### [Comparative Examples 1 to 5]

Long metal film-coated heat-resistant resin films were fabricated using the deposition apparatus (sputtering web coater) accordingly to the conventional example illustrated in FIG. 10. As the long heat-resistant resin film (hereinafter, referred to as the film 214), the heat-resistant polyimide film "UPILEX (registered trademark)", manufactured by Ube Industries, Ltd, measuring 500 mm in width, 800 m in length, and 25 µm in thickness was used.

As the can roll 231, a can roll with a gas introduction mechanism having a jacket roll structure as illustrated in FIG. 9 was used. As the cylindrical member 10 (see FIG. 9) of this can roll 231, a stainless cylindrical member measuring 800 mm in diameter and 800 mm in width was used, and hard chromium plating was performed on its outer peripheral surface. 180 gas introduction channels 14 (see FIG. 9) were bored over the entire circumference of a thick portion of this cylindrical member 10 at equal intervals in the circumferential direction, the gas introduction channels 14 measuring 5 mm in inner diameter and extending in parallel to the direction of the rotation axis of the can roll 231. Note that, of the two ends of each gas introduction channel 14, the distal end was formed into a closed bottom so as not to penetrate through the cylindrical member 10.

Each gas introduction channel 14 was provided with 47 gas discharge holes 15 (see FIG. 9) measuring 0.2 mm in inner diameter and opening toward the outer surface of the cylindrical member 10 (i.e. the outer peripheral surface of the can roll 231). These 47 gas discharge holes 15 were arranged at 10-mm intervals in a direction perpendicular to the direction of advance of the film 214 within a region between lines situated 20 mm inward from both sides of the transfer path of the film 214 defined on the outer surface of the cylindrical member 10. Specifically, the gas discharge holes 15 were not provided within 145-mm regions from both sides of the outer peripheral surface of the can roll 231.

As described above, 180 gas introduction channels 14 were arranged over the entire circumference of the cylindrical member 10 at equal intervals in the circumferential direction. It is difficult to directly connect these 180 gas introduction channels 14 to the rotary joint 20 (see FIG. 9). For this reason, sets of five gas introduction channels 14 were connected to branched pipes (not illustrated) and then connected to the ends of the connection pipes 25 on the rotary ring unit 21. Specifically, on the rotary ring unit 21 of the rotary joint 20, 36 connection pipes 25 were formed, as mentioned above, through each of which the gas was introduced collectively for 10°.

As for the metal films formed on the film 214, a Cu film was formed on an Ni-Cr film, which was a seed layer. To do so, an Ni-Cr target was used as the magnetron sputter target 239, and Cu targets were used as the magnetron sputter targets 240, 241, and 242.

The film 214 in a rolled up state was set on the unwinding roll 215 of the above deposition apparatus (sputtering web coater), and one end of the film 214 was attached to the winding roll 246 through the can roll 231. In this state, the air in the vacuum chamber in the deposition chamber 212 was evacuated to 5 Pa by using a plurality of dry pumps and evacuated further to 3 × 10⁻³ Pa by using a plurality of turbomolecular pumps and cryocoils.

Subsequently, a rotational drive apparatus was actuated to transfer the long film 214 at a transfer speed of 8 m/min while an argon gas was introduced at 300 sccm and also electric power control was performed to apply an electric power of 20 kW to the magnetron sputter cathodes 239, 240, 241, and 242. Further, with a diaphragm gauge attached to the pressure gauge port 82, 83 (see FIG. 8) in the rotary joint mounted to the can roll 231, the flow rate of the argon gas from the supply pipe 26 of the fixed ring unit 22 was controlled such that the set gas pressure in the gaps between the surface of the can roll and the film could be at the value (450 to 1125 Pa) listed in table 1-3 below.

A treatment of continuously forming a seed layer made of an Ni-Cr film and a Cu film to be formed on the seed layer was started under the above conditions on one surface of the film 214 transferred in a roll-to-roll manner.

Note that tables 1-1 to 1-3 below list the "Unwinding Tension" (measured by the tension measurement roll 217 illustrated in FIG. 10), the "Drying Tension" (measured by the tension measurement roll 221), the "Infeed Tension Tu1" (measured by the infeed-side tension measurement roll 230), the "Outfeed Tension Td1"(measured by the outfeed-side tension measurement roll 232), and the "Winding Tension" (measured by the tension measurement roll 244) in comparative examples 1 to 5.

In addition, the "Reaction Pa" (the force with which the long film 214 is pressed against the can roll 231) and the "Set Gas Pressure Pa in Gaps" (equal to 90% of the reaction Pa) in comparative examples 1 to 5, which are determined depending on the setting of the "Infeed Tension Tu1" and the "Outfeed Tension Td1", are listed as well.

**Table 1-1**

| Example Name | Tension Zone | Unwinding Tension | Drying Tension |
|---|---|---|---|
| | Unit | N | N |
| | Tension Measurement Roll No. | 117 | 121 |
| Reference Example: | | | |
| 1 | SET TENSION | 100 | 50 |
| 2 | SET TENSION | 100 | 50 |
| 3 | SET TENSION | 100 | 50 |
| 4 | SET TENSION | 100 | 50 |
| 5 | SET TENSION | 100 | 50 |
| 6 | SET TENSION | 100 | 50 |

| Example: | | | |
|---|---|---|---|
| 1 | SET TENSION | 100 | 50 |
| 2 | SET TENSION | 100 | 50 |

| Reference Example: | | | |
|---|---|---|---|
| 7 | SET TENSION | 100 | 50 |

| | Tension Measurement Roll No. | 217 | 221 |
|---|---|---|---|
| Comparative Example: | | | |
| 1 | SET TENSION | 100 | 50 |
| 2 | SET TENSION | 100 | 50 |
| 3 | SET TENSION | 100 | 50 |
| 4 | SET TENSION | 100 | 50 |
| 5 | SET TENSION | 100 | 50 |

**Table 1-2**

| Example Name | Tension Zone | Infeed Tension Tu2 | Infeed Tension Tu1 | Outfeed Tension Td1 | Outfeed Tension Td2 |
|---|---|---|---|---|---|
| | Unit | N | N | N | N |
| | Tension Measurement Roll No. | 127 | 130 | 132 | 135 |
| Reference Example: | | | | | |
| 1 | SET TENSION | 100 | 100 | 100 | 100 |
| 2 | SET TENSION | 150 | 150 | 150 | 150 |
| 3 | SET TENSION | 50 | 200 | 200 | 100 |
| 4 | SET TENSION | 50 | 250 | 250 | 100 |
| 5 | SET TENSION | 75 | 100 | 100 | 100 |
| 6 | SET TENSION | 100 | 150 | 150 | 125 |

| Example: | | | | | |
|---|---|---|---|---|---|
| 1 | SET TENSION | 125 | 200 | 200 | 150 |
| 2 | SET TENSION | 150 | 250 | 250 | 175 |

| Reference Example: | | | | | |
|---|---|---|---|---|---|
| 7 | SET TENSION | 175 | 300 | 300 | 200 |

| | Tension Measurement Roller No. | | | 230 | 232 |
|---|---|---|---|---|---|
| Comparative Example: | | | | | |
| 1 | SET TENSION | | | 100 | 100 |
| 2 | SET TENSION | | | 150 | 150 |
| 3 | SET TENSION | | | 200 | 200 |
| 4 | SET TENSION | | | 250 | 250 |
| 5 | SET TENSION | | | 250 | 250 |

**Table 1-3**

| Example Name | Tension Zone | Winding Tension | Reaction | Set Gas Pressure in Gaps | Wrinkles by Sputter Thermal Load |
|---|---|---|---|---|---|
| | Unit | N | Pa | Pa | < 675 |
| | Tension Measurement Roll No. | 144 | | | |
| Reference Example: | | | | | |
| 1 | SET TENSION | 100 | 500 | 450 | YES |
| 2 | SET TENSION | 100 | 750 | 675 | YES |
| 3 | SET TENSION | 100 | 1000 | 900 | NO |
| 4 | SET TENSION | 100 | 1250 | 1125 | NO |
| 5 | SET TENSION | 100 | 500 | 450 | YES |
| 6 | SET TENSION | 100 | 750 | 675 | YES |

| Example: | | | | | |
|---|---|---|---|---|---|
| 1 | SET TENSION | 100 | 1000 | 900 | NO |
| 2 | SET TENSION | 100 | 1250 | 1125 | NO |

| Reference Example: | | | | | |
|---|---|---|---|---|---|
| 7 | SET TENSION | 100 | 1500 | 1350 | NO |

| | Tension Measurement Roller No. | 244 | | | |
|---|---|---|---|---|---|
| Comparative Example: | | | | | |
| 1 | SET TENSION | 100 | 500 | 450 | YES |
| 2 | SET TENSION | 100 | 750 | 675 | YES |
| 3 | SET TENSION | 100 | 1000 | 900 | NO |
| 4 | SET TENSION | 100 | 1250 | 1125 | NO |
| 5 | SET TENSION | 100 | 1250 | 1125 | NO |

**Table 1-4**

| Example Name | Tension Zone | Infeed Tension Tu1 - Tu2 | Outfeed Tension Td1 - Td2 | Scratches |
|---|---|---|---|---|
| | Unit | | | ≥ 100 N |
| | Tension Measurement Roll No. | | | |
| Reference Example: | | | | |
| 1 | SET TENSION | 0 | 0 | NO |
| 2 | SET TENSION | 0 | 0 | NO |
| 3 | SET TENSION | 150 | 100 | YES |
| 4 | SET TENSION | 200 | 150 | YES |
| 5 | SET TENSION | 25 | 0 | NO |
| 6 | SET TENSION | 50 | 25 | NO |

| Example: | | | | |
|---|---|---|---|---|
| 1 | SET TENSION | 75 | 50 | NO |
| 2 | SET TENSION | 100 | 75 | NO |

| Reference Example: | | | | |
|---|---|---|---|---|
| 7 | SET TENSION | 125 | 100 | YES |

| | Tension Measurement Roller No. | Infeed Tension Tu1 - Drying Tension | Outfeed Tension Td1 - Winding Tension | |
|---|---|---|---|---|
| Comparative Example: | | | | |
| 1 | SET TENSION | 50 | 0 | NO |
| 2 | SET TENSION | 100 | 50 | NO |
| 3 | SET TENSION | 150 | 100 | YES |
| 4 | SET TENSION | 200 | 150 | YES |
| 5 | SET TENSION | 200 | 150 | YES |

### [Evaluation]

(1) The long films after the deposition according to examples 1 and 2, reference examples 1 to 7, and comparative examples 1 to 5 were visually observed as for whether or not film wrinkles (wrinkles by sputter thermal load) and scratches were formed.
(2) From the result, it could be observed that film wrinkles (wrinkles by sputter thermal load) were formed when the "Set Gas Pressure Pa in Gaps" was lower than 675 Pa (see reference examples 1 and 2, reference examples 5 and 6, and comparative examples 1 and 2).
   It appears that when the "Set Gas Pressure Pa in Gaps" was lower than 675 Pa, the thermal conductance (heat transfer efficiency) of the gap regions (clearances) between the outer peripheral surface of the can roll and the long film wrapped on the outer peripheral surface of the can roll was lowered such that film wrinkles were formed.
(3) On the other hand, it could be observed that scratches were formed when the tension difference between the "Infeed Tension Tu1" of the long film infed toward the can roll and the adjacent "Infeed Tension Tu2" (with the deposition apparatus illustrated in FIG. 1) or the adjacent "Drying Tension" (with the deposition apparatus illustrated in FIG. 10) was higher than 100 N (newton) (see reference examples 3 and 4, reference example 7, and comparative examples 3 to 5) and also when the tension difference between the "Outfeed Tension Td1" of the long film outfed from the can roll and the adjacent "Outfeed Tension Td2" (with the deposition apparatus illustrated in FIG. 1) or the adjacent "Winding Tension" (with the deposition apparatus illustrated in FIG. 10) was higher than 100 N (newton) (see reference example 4 and comparative examples 4 and 5).
   It appears that, when the tension difference was higher than 100 N (newton), it was difficult to control the tension difference with the motor driven rolls, the can roll, and so on, which caused slippage, vibration, or the like of the long film on the surface of the can roll, thereby making the tension unstable and forming scratches or the like.
(4) Further, it was observed that neither film wrinkles (wrinkles by sputter thermal load) nor scratches were formed in examples 1 and 2, which used the deposition apparatus (sputtering web coater) according to the present invention illustrated in FIG. 1. On the other hand, it was observed that either film wrinkles (wrinkles by sputter thermal load) or scratches were formed in comparative examples 1 to 5, which used the deposition apparatus (sputtering web coater) according to the conventional example illustrated in FIG. 10.

### POSSIBILITY OF INDUSTRIAL APPLICATION

The long substrate treatment apparatus and treatment method according to the present invention can avoid formation of film wrinkles and scratches. The long substrate treatment apparatus and treatment method according to the present invention therefore have a possibility of industrial application that they are employed as a manufacturing apparatus and manufacturing method for copper-laminated resin films (metal film-coated heat-resistant resin films) for use as flexible wiring substrates in liquid crystal televisions, mobile phones, and so on.

An apparatus that performs sputtering or the like on a long film 114 supplied from an unwinding chamber 110 and wrapped on a can roll 131 with a gas discharge mechanism in a deposition chamber 112 is characterized in that the apparatus includes a pair of tension control roll groups (a first tension measurement roll 130 and first motor driven roll 129, and a second tension measurement roll 127 and second motor driven roll 125) on the film infeed side of the can roll, and also a pair of tension control roll groups (a first tension measurement roll 132 and first motor driven roll 133, and a second tension measurement roll 135 and second motor driven roll 137) on the outfeed side of the can roll. Two-stage control of the infeed feed tension and the outfeed feed tension of the can roll is performed using the two pairs of tension control roll groups, respectively. This allows accurate control on the tension of the film and thus makes it possible to avoid formation of scratches or the like.

## Claims

1. A long substrate treatment apparatus which comprises:
an unwinding zone in which to unwind a long substrate (52, 114) wound around an unwinding roll (115);
a treatment zone in which to perform a treatment that applies a thermal load in a vacuum chamber on the long substrate (52, 114) fed from the unwinding zone; and
a winding zone in which to wind the long substrate (52, 114) subjected to the treatment,
the treatment zone comprising
a motor driven can roll (56, 131) that cools the long substrate (52, 114) transferred in a roll-to-roll manner and wrapped on an outer peripheral surface of the can roll (56, 131),
an infeed-side tension control roll group and an outfeed-side tension control roll group provided on an infeed side and an outfeed side of the can roll (56, 131) where the long substrate (52, 114) is infed toward and outfed from the can roll (56, 131), respectively, and
thermal load applying treatment means (139, 140, 141, 142) positioned so as to face the outer peripheral surface of the can roll (56, 131),
a plurality of gas introduction channels (14) being arranged over an entire circumference of the can roll (56, 131) at substantially equal intervals in a circumferential direction, the plurality of gas introduction channels (14) each comprising a plurality of gas discharge holes (15) opening toward the outer peripheral surface at substantially equal intervals along a direction of a rotary shaft (12) of the can roll (56, 131), and
the long substrate treatment apparatus comprising a rotary joint (20) that supplies a gas from outside the vacuum chamber to the gas introduction channels (14) situated within an angular range of the outer peripheral surface of the can roll (56, 131) within which the long substrate (52, 114) is wrapped, and does not supply the gas from outside the vacuum chamber to the gas introduction channels (14) not situated within the angular range within which the long substrate (52, 114) is wrapped,
**characterized in that**
the infeed-side tension control roll group comprises a first infeed-side tension control roll group and a second infeed-side tension control roll group each provided in the treatment zone, the first infeed-side tension control roll group comprising a first infeed-side tension measurement roll (130) disposed near the infeed side of the can roll (56, 131) and a first infeed-side motor driven roll (129) whose circumferential speed is controlled based on a tension of the long substrate (52, 114) measured by the first infeed-side tension measurement roll (130), the second infeed-side tension control roll group comprising a second infeed-side tension measurement roll (127) disposed on the first infeed-side motor driven roll (129) side and a second infeed-side motor driven roll (125) whose circumferential speed is controlled based on a tension of the long substrate (52, 114) measured by the second infeed-side tension measurement roll (127),
the outfeed-side tension control roll group comprises a first outfeed-side tension control roll group and a second outfeed-side tension control roll group each provided in the treatment zone, the first outfeed-side tension control roll group comprising a first outfeed-side tension measurement roll (132) disposed near the outfeed side of the can roll (56, 131) and a first outfeed-side motor driven roll (133) whose circumferential speed is controlled based on a tension of the long substrate (52, 114) measured by the first outfeed-side tension measurement roll (132), the second outfeed-side tension control roll group comprising a second outfeed-side tension measurement roll (135) disposed on the first outfeed-side motor driven roll (133) side and a second outfeed-side motor driven roll (137) whose circumferential speed is controlled based on a tension of the long substrate (52, 114) measured by the second outfeed-side tension measurement roll (135),
a tension of the long substrate (52, 114) infed toward the can roll (56, 131) in the direction of the infeed is adjusted by two-stage control using an infeed tension (Tu1) set based on a difference in circumferential speed between the can roll (56, 131) and the first infeed-side motor driven roll (129) and an infeed tension (Tu2) (Tu1 > Tu2) set based on a difference in circumferential speed between the first infeed-side motor driven roll (129) and the second infeed-side motor driven roll (125), and
a tension of the long substrate (52, 114) outfed from the can roll (56, 131) in the direction of the outfeed is adjusted by two-stage control using an outfeed tension (Td1) set based on a difference in circumferential speed between the first outfeed-side motor driven roll (133) and the can roll (56, 131), and an outfeed tension (Td2) (Td1 > Td2) set based on a difference in circumferential speed between the second outfeed-side motor driven roll (137) and the first outfeed-side motor driven roll (133).

2. The long substrate treatment apparatus according to claim 1, **characterized in that**
the rotary joint (20) comprises a rotary ring unit (21) and a fixed ring unit (22) provided coaxially with the can roll (56, 131) and each comprising a gas control sliding contact surface formed perpendicularly to a center axis (56a) of the can roll (56, 131),
the rotary ring unit (21) comprises a plurality of gas supply channels (23) communicating with the plurality of gas introduction channels (14) in the can roll (56, 131), respectively, the plurality of gas supply channels (23) each comprising a revolving opening portion (23a) at the gas control sliding contact surface of the rotary ring unit (21), the revolving opening portion (23a) opening at an angular position corresponding to an angular position, on the outer peripheral surface of the can roll (56, 131), of the gas introduction channel (14) communicating with the gas supply channel (23),
the fixed ring unit (22) comprises a gas distribution channel (27) formed by an annular recessed groove (27a), comprising a fixed closed portion and a fixed opening portion, and communicating with a supply pipe (26) outside the vacuum chamber, the annular recessed groove (27a) being provided in the gas control sliding contact surface of the fixed ring unit (22) so as to extend in the circumferential direction, the fixed closed portion being a portion at which the gas control sliding contact surface of the fixed ring unit (22) is closed by an arched packing member (42) fitted in a predetermined region inside the annular recessed groove (27a), the fixed opening portion being a portion at which the gas control sliding contact surface is not closed, and
the fixed opening portion opens within an angular range in a region on the gas control sliding contact surface of the fixed ring unit (22) which the revolving opening portions (23a) of the rotary ring unit (21) face, the angular range being a range within which the long substrate (52, 114) is wrapped.

3. The long substrate treatment apparatus according to claim 1, **characterized in that**
the rotary joint (20) comprises a rotary ring unit (21) having a T-shaped cross section and comprising a cylindrical base part (21a) and a cylindrical protruding part (21b) provided coaxially with the can roll (56, 131), and a cylindrical fixed ring unit (22) in which the cylindrical protruding part (21b) of the rotary ring unit (21) is fitted such that the cylindrical protruding part (21b) and the fixed ring unit (22) each comprise a gas control sliding contact surface in parallel to a center axis (56a) of the can roll (56, 131),
the rotary ring unit (21) comprises a plurality of gas supply channels (23) communicating with the plurality of gas introduction channels (14) in the can roll (56, 131), respectively, the plurality of gas supply channels (23) each comprising a revolving opening portion (23a) at the gas control sliding contact surface of the cylindrical protruding part (21b) of the rotary ring unit (21), the revolving opening portion (23a) opening at an angular position corresponding to an angular position, on the outer peripheral surface of the can roll (56, 131), of the gas introduction channel (14) communicating with the gas supply channel (23),
the fixed ring unit (22) comprises a gas distribution channel (27) formed by an annular recessed groove (27a), comprising a fixed closed portion and a fixed opening portion, and communicating with a supply pipe (26) outside the vacuum chamber, the annular recessed groove (27a) being provided in a cylindrical inner circumferential surface of the fixed ring unit (22) so as to extend in the circumferential direction, the fixed closed portion being a portion at which the gas control sliding contact surface of the fixed ring unit (22) is closed by an arched packing member (42) fitted in a predetermined region inside the annular recessed groove (27a), the fixed opening portion being a portion at which the gas control sliding contact surface is not closed, and
the fixed opening portion opens within an angular range in a region on the gas control sliding contact surface of the fixed ring unit (22) which the revolving opening portions (23a) of the cylindrical protruding part (21b) of the rotary ring unit (21) face, the angular range being a range within which the long substrate (52, 114) is wrapped.

4. The long substrate treatment apparatus according to any one of claims 1 to 3, **characterized in that** the treatment that applies a thermal load is a treatment with vacuum deposition means facing a transfer path defined on the outer peripheral surface of the can roll (56, 131).

5. The long substrate treatment apparatus according to claim 4, **characterized in that** the vacuum deposition means comprises a magnetron sputtering cathode.

6. A long substrate treatment method which uses:
an unwinding zone in which to unwind a long substrate (52, 114) wound around an unwinding roll (115),
a treatment zone in which to perform a treatment that applies a thermal load in a vacuum chamber on the long substrate (52, 114) fed from the unwinding zone, and
a winding zone in which to wind the long substrate (52, 114) subjected to the treatment,
the long substrate treatment method comprising
forming the treatment zone from
a motor driven can roll (56, 131) that cools the long substrate (52, 114) transferred in a roll-to-roll manner and wrapped on an outer peripheral surface of the can roll (56, 131),
an infeed-side tension control roll group and an outfeed-side tension control roll group provided on an infeed side and an outfeed side of the can roll (56, 131) where the long substrate (52, 114) is infed toward and outfed from the can roll (56, 131), respectively, and
thermal load applying treatment means (139, 140, 141, 142) positioned so as to face the outer peripheral surface of the can roll (56, 131),
arranging a plurality of gas introduction channels (14) over an entire circumference of the can roll (56, 131) at substantially equal intervals in a circumferential direction, the plurality of gas introduction channels (14) each comprising a plurality of gas discharge holes (15) opening toward the outer peripheral surface at substantially equal intervals along a direction of a rotary shaft (12) of the can roll (56, 131), and
providing the can roll with a rotary joint (20) to supply a gas from outside the vacuum chamber to the gas introduction channels (14) situated within an angular range of the outer peripheral surface of the can roll (56, 131) within which the long substrate (52, 114) is wrapped, and not to supply the gas from outside the vacuum chamber to the gas introduction channels (14) not situated within the angular range within which the long substrate (52, 114) is wrapped,
**characterized in that** the long substrate treatment method comprises:
forming the infeed-side tension control roll group from a first infeed-side tension control roll group and a second infeed-side tension control roll group each provided in the treatment zone, the first infeed-side tension control roll group comprising a first infeed-side tension measurement roll (130) disposed near the infeed side of the can roll (56, 131) and a first infeed-side motor driven roll (129) whose circumferential speed is controlled based on a tension of the long substrate (52, 114) measured by the first infeed-side tension measurement roll (130), the second infeed-side tension control roll group comprising a second infeed-side tension measurement roll (127) disposed on the first infeed-side motor driven roll (129) side and a second infeed-side motor driven roll (125) whose circumferential speed is controlled based on a tension of the long substrate (52, 114) measured by the second infeed-side tension measurement roll (127);
forming the outfeed-side tension control roll group from a first outfeed-side tension control roll group and a second outfeed-side tension control roll group each provided in the treatment zone, the first outfeed-side tension control roll group comprising a first outfeed-side tension measurement roll (132) disposed near the outfeed side of the can roll (56, 131) and a first outfeed-side motor driven roll (133) whose circumferential speed is controlled based on a tension of the long substrate (52, 114) measured by the first outfeed-side tension measurement roll (132), the second outfeed-side tension control roll group comprising a second outfeed-side tension measurement roll (135) disposed on the first outfeed-side motor driven roll (133) side and a second outfeed-side motor driven roll (137) whose circumferential speed is controlled based on a tension of the long substrate (52, 114) measured by the second outfeed-side tension measurement roll (135);
adjusting a tension of the long substrate (52, 114) infed toward the can roll (56, 131) in the direction of the infeed by two-stage control using an infeed tension (Tu1) set based on a difference in circumferential speed between the can roll (56, 131) and the first infeed-side motor driven roll (129) and an infeed tension (Tu2) (Tu1 > Tu2) set based on a difference in circumferential speed between the first infeed-side motor driven roll (129) and the second infeed-side motor driven roll (125); and
adjusting a tension of the long substrate (52, 114) outfed from the can roll (56, 131) in the direction of the outfeed by two-stage control using an outfeed tension (Td1) set based on a difference in circumferential speed between the first outfeed-side motor driven roll (133) and the can roll (56, 131), and an outfeed tension (Td2) (Td1 > Td2) set based on a difference in circumferential speed between the second outfeed-side motor driven roll (137) and the first outfeed-side motor driven roll (133).

## Patentansprüche

1. Vorrichtung zur Behandlung langer Substrate, die umfasst:
eine Abwickelzone, in der ein langes Substrat (52, 114), das um eine Abwickelrolle (115) aufgewickelt ist, abgewickelt wird;
eine Behandlungszone, in der eine Behandlung durchgeführt wird, die eine thermische Belastung in einer Vakuumkammer auf das lange Substrat (52, 114) aufbringt, das von der Abwickelzone zugeführt wird; und
eine Aufwickelzone, in der das lange Substrat (52, 114), das der Behandlung unterzogen wurde, aufgewickelt wird,
wobei die Behandlungszone umfasst
eine motorgetriebene Dosenrolle (56, 131), die das lange Substrat (52, 114) kühlt, das in einer Rolle-zu-Rolle-Weise übertragen und auf eine äußere Umfangsfläche der Dosenrolle (56, 131) aufgewickelt wird,
eine zuführseitige Spannungssteuerungsrollengruppe und eine abführseitige Spannungssteuerungsrollengruppe, die auf einer Zuführseite und einer Abführseite der Dosenrolle (56, 131) bereitgestellt sind, wobei das lange Substrat (52, 114) der Dosenrolle (56, 131) zugeführt bzw. von dieser abgeführt wird, und
Mittel (139, 140, 141, 142) zum Aufbringen einer thermischen Belastung, die so angeordnet sind, dass sie der äußeren Umfangsfläche der Dosenrolle (56, 131) zugewandt sind,
eine Mehrzahl von Gaseinführungskanälen (14), die über einen gesamten Umfang der Dosenrolle (56, 131) in im Wesentlichen gleichen Abständen in einer Umfangsrichtung angeordnet sind, wobei die Mehrzahl von Gaseinführungskanälen (14) jeweils eine Mehrzahl von Gasauslassöffnungen (15) umfasst, die sich in im Wesentlichen gleichen Abständen entlang einer Richtung einer Drehwelle (12) der Dosenrolle (56, 131) zur äußeren Umfangsfläche hin öffnen, und
wobei die Vorrichtung zur Behandlung langer Substrate eine Drehverbindung (20) umfasst, die ein Gas von außerhalb der Vakuumkammer den Gaseinführungskanälen (14) zuführt, die sich in einem Winkelbereich der äußeren Umfangsfläche der Dosenrolle (56, 131) befinden, in der das lange Substrat (52, 114) aufgewickelt ist, und das Gas nicht von außerhalb der Vakuumkammer den Gaseinführungskanälen (14) zuführt, die sich nicht in dem Winkelbereich befinden, in dem das lange Substrat (52, 114) aufgewickelt ist,
**dadurch gekennzeichnet, dass**
die zuführseitige Spannungssteuerungsrollengruppe eine erste zuführseitige Spannungssteuerungsrollengruppe und eine zweite zuführseitige Spannungssteuerungsrollengruppe umfasst, die jeweils in der Behandlungszone bereitgestellt sind, wobei die erste zuführseitige Spannungssteuerungsrollengruppe eine erste zuführseitige Spannungsmessrolle (130), die nahe der Zuführseite der Dosenrolle (56, 131) angeordnet ist, und eine erste zuführseitige motorgetriebene Rolle (129) umfasst, deren Umfangsgeschwindigkeit auf der Grundlage einer Spannung des langen Substrats (52, 114) gesteuert wird, die durch die erste zuführseitige Spannungsmessrolle (130) gemessen wird, wobei die zweite zuführseitige Spannungssteuerungsrollengruppe eine zweite zuführseitige Spannungsmessrolle (127), die auf der Seite der ersten zuführseitigen motorgetriebenen Rolle (129) angeordnet ist, und eine zweite zuführseitige motorgetriebene Rolle (125) umfasst, deren Umfangsgeschwindigkeit auf der Grundlage einer Spannung des langen Substrats (52, 114) gesteuert wird, die durch die zweite zuführseitige Spannungsmessrolle (127) gemessen wird,
die abführseitige Spannungssteuerungsrollengruppe eine erste abführseitige Spannungssteuerungsrollengruppe und eine zweite abführseitige Spannungssteuerungsrollengruppe umfasst, die jeweils in der Behandlungszone bereitgestellt sind, wobei die erste abführseitige Spannungssteuerungsrollengruppe eine erste abführseitige Spannungsmessrolle (132), die nahe der Abführseite der Dosenrolle (56, 131) angeordnet ist, und eine erste abführseitige motorgetriebene Rolle (133) umfasst, deren Umfangsgeschwindigkeit auf der Grundlage einer Spannung des langen Substrats (52, 114) gesteuert wird, die von der ersten abführseitigen Spannungsmessrolle (132) gemessen wird, wobei die zweite abführseitige Spannungssteuerungsrollengruppe eine zweite abführseitige Spannungsmessrolle (135), die auf der Seite der ersten abführseitigen motorgetriebenen Rolle (133) angeordnet ist, und eine zweite abführseitige motorgetriebene Rolle (137) umfasst, deren Umfangsgeschwindigkeit auf der Grundlage einer Spannung des langen Substrats (52, 114) gesteuert wird, die von der zweiten abführseitigen Spannungsmessrolle (135) gemessen wird,
eine Spannung des langen Substrats (52, 114), das zu der Dosenrolle (56, 131) in Richtung der Zufuhr zugeführt wird, durch eine zweistufige Steuerung unter Verwendung einer Zuführspannung (Tu1), die auf der Grundlage einer Differenz der Umfangsgeschwindigkeit zwischen der Dosenrolle (56, 131) und der ersten zuführseitigen motorgetriebenen Rolle (129) bestimmt wird, und einer Zuführspannung (Tu2) (Tu1 > Tu2), die auf der Grundlage einer Differenz der Umfangsgeschwindigkeit zwischen der ersten zuführseitigen motorgetriebenen Rolle (129) und der zweiten zuführseitigen motorgetriebenen Rolle (125) bestimmt wird, eingestellt wird, und
eine Spannung des langen Substrats (52, 114), das von der Dosenrolle (56, 131) in der Richtung der Abführung abgeführt wird, durch eine zweistufige Steuerung unter Verwendung einer Abführspannung (Td1), die auf der Grundlage einer Differenz in der Umfangsgeschwindigkeit zwischen der ersten abführseitigen motorgetriebenen Rolle (133) und der Dosenrolle (56, 131) bestimmt wird, und einer Abführspannung (Td2) (Td1 > Td2), die auf der Grundlage einer Differenz in der Umfangsgeschwindigkeit zwischen der zweiten abführseitigen motorgetriebenen Rolle (137) und der ersten abführseitigen motorgetriebenen Rolle (133) bestimmt wird, eingestellt wird.

2. Vorrichtung zur Behandlung langer Substrate nach Anspruch 1, **dadurch gekennzeichnet, dass**
die Drehverbindung (20) eine Drehringeinheit (21) und eine feststehende Ringeinheit (22) umfasst, die koaxial mit der Dosenrolle (56, 131) bereitgestellt sind und jeweils eine Gassteuerungs-Gleitkontaktfläche aufweisen, die senkrecht zu einer Mittelachse (56a) der Dosenrolle (56, 131) ausgebildet ist,
die Drehringeinheit (21) eine Mehrzahl von Gaszufuhrkanälen (23) umfasst, die jeweils mit der Mehrzahl von Gaseinführungskanälen (14) in der Dosenrolle (56, 131) in Verbindung stehen, wobei die Mehrzahl von Gaszufuhrkanälen (23) jeweils einen drehbaren Öffnungsabschnitt (23a) an der Gassteuerungs-Gleitkontaktfläche der Drehringeinheit (21) umfasst, wobei sich der drehbare Öffnungsabschnitt (23a) an einer Winkelposition öffnet, die einer Winkelposition des Gaseinführungskanals (14), der mit dem Gaszufuhrkanal (23) in Verbindung steht, an der äußeren Umfangsfläche der Dosenrolle (56, 131) entspricht,
die feststehende Ringeinheit (22) einen Gasverteilungskanal (27) aufweist, der durch eine ringförmige vertiefte Nut (27a) gebildet ist, die einen feststehenden geschlossenen Abschnitt und einen feststehenden Öffnungsabschnitt aufweist und mit einem Zuführrohr (26) außerhalb der Vakuumkammer in Verbindung steht, wobei die ringförmige vertiefte Nut (27a) in der Gassteuerungs-Gleitkontaktfläche der feststehenden Ringeinheit (22) so bereitgestellt ist, dass sie sich in der Umfangsrichtung erstreckt, wobei der feststehende geschlossene Abschnitt ein Abschnitt ist, an dem die Gassteuerungs-Gleitkontaktfläche der feststehenden Ringeinheit (22) durch ein bogenförmiges Dichtungselement (42) geschlossen ist, das in einem vorbestimmten Bereich innerhalb der ringförmigen vertieften Nut (27a) eingepasst ist, wobei der feststehende Öffnungsabschnitt ein Abschnitt ist, an dem die Gassteuerungs-Gleitkontaktfläche nicht geschlossen ist, und
der feststehende Öffnungsabschnitt sich innerhalb eines Winkelbereichs in einem Bereich auf der Gassteuerungs-Gleitkontaktfläche der feststehenden Ringeinheit (22) öffnet, dem die drehbaren Öffnungsabschnitte (23a) der Drehringeinheit (21) zugewandt sind, wobei der Winkelbereich ein Bereich ist, innerhalb dessen das lange Substrat (52, 114) aufgewickelt ist.

3. Vorrichtung zur Behandlung langer Substrate nach Anspruch 1, **dadurch gekennzeichnet, dass**
die Drehverbindung (20) eine Drehringeinheit (21), die einen T-förmigen Querschnitt hat und ein zylindrisches Basisteil (21a) und ein zylindrisches, vorstehendes Teil (21b) umfasst, das koaxial mit der Dosenrolle (56, 131) bereitgestellt ist, und eine zylindrische feststehende Ringeinheit (22) umfasst, in die der zylindrische vorstehende Teil (21b) der Drehringeinheit (21) so eingepasst ist, dass der zylindrische vorstehende Teil (21b) und die feststehende Ringeinheit (22) jeweils eine Gassteuerungs-Gleitkontaktfläche parallel zu einer Mittelachse (56a) der Dosenrolle (56, 131) aufweisen,
die Drehringeinheit (21) eine Mehrzahl von Gaszufuhrkanälen (23) umfasst, die jeweils mit der Mehrzahl von Gaseinführungskanälen (14) in der Dosenrolle (56, 131) in Verbindung stehen, wobei die Mehrzahl von Gaszufuhrkanälen (23) jeweils einen drehbaren Öffnungsabschnitt (23a) an der Gassteuerungs-Gleitkontaktfläche des zylindrischen, vorstehenden Teils (21b) der Drehringeinheit (21) umfasst, wobei sich der drehbare Öffnungsabschnitt (23a) an einer Winkelposition öffnet, die einer Winkelposition des Gaseinführungskanals (14), der mit dem Gaszufuhrkanal (23) in Verbindung steht, an der äußeren Umfangsfläche der Dosenrolle (56, 131) entspricht,
die feststehende Ringeinheit (22) einen Gasverteilungskanal (27) aufweist, der durch eine ringförmige vertiefte Nut (27a) gebildet ist, die einen feststehenden geschlossenen Abschnitt und einen feststehenden Öffnungsabschnitt aufweist und mit einem Zuführrohr (26) außerhalb der Vakuumkammer in Verbindung steht, wobei die ringförmige vertiefte Nut (27a) in einer zylindrischen inneren Umfangsfläche der feststehenden Ringeinheit (22) so bereitgestellt ist, dass sie sich in der Umfangsrichtung erstreckt, wobei der feststehende geschlossene Abschnitt ein Abschnitt ist, an dem die Gassteuerungs-Gleitkontaktfläche der feststehenden Ringeinheit (22) durch ein bogenförmiges Dichtungselement (42) geschlossen ist, das in einem vorbestimmten Bereich innerhalb der ringförmigen vertieften Nut (27a) eingepasst ist, wobei der feststehende Öffnungsabschnitt ein Abschnitt ist, an dem die Gassteuerungs-Gleitkontaktfläche nicht geschlossen ist, und
der feststehende Öffnungsabschnitt sich innerhalb eines Winkelbereichs in einem Bereich auf der Gassteuerungs-Gleitkontaktfläche der feststehenden Ringeinheit (22) öffnet, dem die drehbaren Öffnungsabschnitte (23a) des zylindrischen, vorstehenden Teils (21b) der Drehringeinheit (21) zugewandt sind, wobei der Winkelbereich ein Bereich ist, innerhalb dessen das lange Substrat (52, 114) aufgewickelt ist

4. Vorrichtung zur Behandlung von langen Substraten nach einem der Ansprüche 1 bis 3, **dadurch gekennzeichnet, dass** die Behandlung, die eine thermische Belastung aufbringt, eine Behandlung mit einem Vakuumbeschichtungsmittel ist, das einem auf der äußeren Umfangsfläche der Dosenrolle (56, 131) definierten Transferpfad gegenüberliegt.

5. Vorrichtung zur Behandlung langer Substrate nach Anspruch 4, **dadurch gekennzeichnet, dass** das Vakuumbeschichtungsmittel eine Magnetron-Sputterkathode umfasst.

6. Behandlungsverfahren für lange Substrate, das verwendet:
eine Abwickelzone, in der ein langes Substrat (52, 114), das um eine Abwickelrolle (115) aufgewickelt ist, abgewickelt wird;
eine Behandlungszone, in der eine Behandlung durchgeführt wird, die eine thermische Belastung in einer Vakuumkammer auf das lange Substrat (52, 114) aufbringt, das von der Abwickelzone zugeführt wird; und
eine Aufwickelzone, in der das lange Substrat (52, 114), das der Behandlung unterzogen wurde, aufgewickelt wird,
wobei das Verfahren zur Behandlung langer Substrate umfasst
Bilden der Behandlungszone aus
einer motorgetriebenen Dosenrolle (56, 131), die das lange Substrat (52, 114) kühlt, das in einer Rolle-zu-Rolle-Weise übertragen und auf eine äußere Umfangsfläche der Dosenrolle (56, 131) aufgewickelt wird,
einer zuführseitigen Spannungssteuerungsrollengruppe und einer abführseitigen Spannungssteuerungsrollengruppe, die auf einer Zuführseite und einer Abführseite der Dosenrolle (56, 131) bereitgestellt sind, wobei das lange Substrat (52, 114) der Dosenrolle (56, 131) zugeführt bzw. von dieser abgeführt wird, und
Mittel (139, 140, 141, 142) zum Aufbringen einer thermischen Belastung, die so angeordnet sind, dass sie der äußeren Umfangsfläche der Dosenrolle (56, 131) zugewandt sind,
Anordnen einer Mehrzahl von Gaseinführungskanälen (14) über einen gesamten Umfang der Dosenrolle (56, 131) in im Wesentlichen gleichen Abständen in einer Umfangsrichtung, wobei die Mehrzahl von Gaseinführungskanälen (14) jeweils eine Mehrzahl von Gasauslassöffnungen (15) umfasst, die sich in im Wesentlichen gleichen Abständen entlang einer Richtung einer Drehwelle (12) der Dosenrolle (56, 131) zur äußeren Umfangsfläche hin öffnen, und
Bereitstellen der Dosenrolle mit einer Drehverbindung (20), um ein Gas von außerhalb der Vakuumkammer den Gaseinführungskanälen (14) zuzuführen, die sich in einem Winkelbereich der äußeren Umfangsfläche der Dosenrolle (56, 131) befinden, in der das lange Substrat (52, 114) aufgewickelt ist, und um das Gas nicht von außerhalb der Vakuumkammer den Gaseinführungskanälen (14) zuzuführen, die sich nicht in dem Winkelbereich befinden, in dem das lange Substrat (52, 114) aufgewickelt ist,
**dadurch gekennzeichnet, dass** das Behandlungsverfahren für lange Substrate umfasst:
Bilden der zuführseitigen Spannungssteuerungsrollengruppe aus einer ersten zuführseitigen Spannungssteuerungsrollengruppe und einer zweiten zuführseitigen Spannungssteuerungsrollengruppe, die jeweils in der Behandlungszone bereitgestellt sind, wobei die erste zuführseitige Spannungssteuerungsrollengruppe eine erste zuführseitige Spannungsmessrolle (130), die nahe der Zuführseite der Dosenrolle (56, 131) angeordnet ist, und eine erste zuführseitige motorgetriebene Rolle (129) umfasst, deren Umfangsgeschwindigkeit auf der Grundlage einer Spannung des langen Substrats (52, 114) gesteuert wird, die durch die erste zuführseitige Spannungsmessrolle (130) gemessen wird, wobei die zweite zuführseitige Spannungssteuerungsrollengruppe eine zweite zuführseitige Spannungsmessrolle (127), die auf der Seite der ersten zuführseitigen motorgetriebenen Rolle (129) angeordnet ist, und eine zweite zuführseitige motorgetriebene Rolle (125) umfasst, deren Umfangsgeschwindigkeit auf der Grundlage einer Spannung des langen Substrats (52, 114) gesteuert wird, die durch die zweite zuführseitige Spannungsmessrolle (127) gemessen wird,
Bilden der abführseitigen Spannungssteuerungsrollengruppe aus einer ersten abführseitigen Spannungssteuerungsrollengruppe und einer zweiten abführseitigen Spannungssteuerungsrollengruppe, die jeweils in der Behandlungszone bereitgestellt sind, wobei die erste abführseitige Spannungssteuerungsrollengruppe eine erste abführseitige Spannungsmessrolle (132), die nahe der Abführseite der Dosenrolle (56, 131) angeordnet ist, und eine erste abführseitige motorgetriebene Rolle (133) umfasst, deren Umfangsgeschwindigkeit auf der Grundlage einer Spannung des langen Substrats (52, 114) gesteuert wird, die von der ersten abführseitigen Spannungsmessrolle (132) gemessen wird, wobei die zweite abführseitige Spannungssteuerungsrollengruppe eine zweite abführseitige Spannungsmessrolle (135), die auf der Seite der ersten abführseitigen motorgetriebenen Rolle (133) angeordnet ist, und eine zweite abführseitige motorgetriebene Rolle (137) umfasst, deren Umfangsgeschwindigkeit auf der Grundlage einer Spannung des langen Substrats (52, 114) gesteuert wird, die von der zweiten abführseitigen Spannungsmessrolle (135) gemessen wird,
Einstellen einer Spannung des langen Substrats (52, 114), das zu der Dosenrolle (56, 131) in Richtung der Zufuhr zugeführt wird, durch eine zweistufige Steuerung unter Verwendung einer Zuführspannung (Tu1), die auf der Grundlage einer Differenz der Umfangsgeschwindigkeit zwischen der Dosenrolle (56, 131) und der ersten zuführseitigen motorgetriebenen Rolle (129) bestimmt wird, und einer Zuführspannung (Tu2) (Tu1 > Tu2), die auf der Grundlage einer Differenz der Umfangsgeschwindigkeit zwischen der ersten zuführseitigen motorgetriebenen Rolle (129) und der zweiten zuführseitigen motorgetriebenen Rolle (125) bestimmt wird, und
Einstellen einer Spannung des langen Substrats (52, 114), das von der Dosenrolle (56, 131) in der Richtung der Abführung abgeführt wird, durch eine zweistufige Steuerung unter Verwendung einer Abführspannung (Td1), die auf der Grundlage einer Differenz in der Umfangsgeschwindigkeit zwischen der ersten abführseitigen motorgetriebenen Rolle (133) und der Dosenrolle (56, 131) bestimmt wird, und einer Abführspannung (Td2) (Td1 > Td2), die auf der Grundlage einer Differenz in der Umfangsgeschwindigkeit zwischen der zweiten abführseitigen motorgetriebenen Rolle (137) und der ersten abführseitigen motorgetriebenen Rolle (133) bestimmt wird.

## Revendications

1. Appareil de traitement de long substrat qui comprend :
une zone de déroulement dans laquelle est déroulé un long substrat (52, 114) enroulé autour d'un rouleau de déroulement (115) ;
une zone de traitement dans laquelle est effectué un traitement qui applique une charge thermique, dans une chambre à vide, au long substrat (52, 114) acheminé par la zone de déroulement ; et
une zone d'enroulement dans laquelle est enroulé le long substrat (52, 114) soumis au traitement,
la zone de traitement comprenant
un rouleau scellé entraîné par moteur (56, 131) qui refroidit le long substrat (52, 114), transféré de rouleau à rouleau, et enveloppé sur une surface périphérique extérieure du rouleau scellé (56, 131),
un groupe de rouleaux de commande de tension du côté entrée et un groupe de rouleaux de commande de tension du côté sortie, prévus sur un côté entrée et un côté sortie du rouleau scellé (56, 131), où le long substrat (52, 114) est entré vers et sorti du rouleau scellé (56, 131), respectivement, et
des moyens de traitement par application de charge thermique (139, 140, 141, 142), positionnés de manière à faire face à la surface périphérique extérieure du rouleau scellé (56, 131),
une pluralité de canaux d'introduction de gaz (14) agencés sur toute une circonférence du rouleau scellé (56, 131) à des intervalles sensiblement égaux dans une direction circonférentielle, la pluralité de canaux d'introduction de gaz (14) comprennent chacun une pluralité de trous de décharge de gaz (15) s'ouvrant vers la surface périphérique extérieure, à des intervalles sensiblement égaux, le long d'une direction d'un arbre rotatif (12) du rouleau scellé (56, 131), et
l'appareil de traitement de long substrat comprend un joint rotatif (20) qui assure l'alimentation en gaz, de l'extérieur de la chambre à vide aux canaux d'introduction de gaz (14) situés dans une plage angulaire de la surface périphérique extérieure du rouleau scellé (56, 131), dans laquelle le long substrat (52, 114) est enveloppé, et qui n'assure pas d'alimentation en gaz, de l'extérieur de la chambre à vide aux canaux d'introduction de gaz (14) qui ne sont pas situés dans la plage angulaire dans laquelle le long substrat (52, 114) est enveloppé,
**caractérisé en ce que**
le groupe de rouleaux de commande de tension du côté entrée comprend un premier groupe de rouleaux de commande de tension du côté entrée et un second groupe de rouleaux de commande de tension du côté entrée, prévus chacun dans la zone de traitement, le premier groupe de rouleaux de commande de tension du côté entrée comprend un premier rouleau de mesure de tension du côté entrée (130) disposé près du côté entrée du rouleau scellé (56, 131), et un premier rouleau entraîné par moteur du côté entrée (129) dont la vitesse circonférentielle est commandée sur la base d'une tension du long substrat (52, 114) mesurée par le premier rouleau de mesure de tension du côté entrée (130), le second groupe de rouleaux de commande de tension du côté entrée comprend un second rouleau de mesure de tension du côté entrée (127) disposé sur le côté du premier rouleau entraîné par moteur du côté entrée (129), et un second rouleau entraîné par moteur du côté entrée (125) dont la vitesse circonférentielle est commandée sur la base d'une tension du long substrat (52, 114) mesurée par le second rouleau de mesure de tension du côté entrée (127),
le groupe de rouleaux de commande de tension du côté sortie comprend un premier groupe de rouleaux de commande de tension du côté sortie et un second groupe de rouleaux de commande de tension du côté sortie, prévus chacun dans la zone de traitement, le premier groupe de rouleaux de commande de tension du côté sortie comprend un premier rouleau de mesure de tension du côté sortie (132) disposé près du côté sortie du rouleau scellé (56, 131), et un premier rouleau entraîné par moteur du côté sortie (133) dont la vitesse circonférentielle est commandée sur la base d'une tension du long substrat (52, 114) mesurée par le premier rouleau de mesure de tension du côté sortie (132), le second groupe de rouleaux de commande de tension du côté sortie comprend un second rouleau de mesure de tension du côté sortie (135) disposé sur le côté du premier rouleau entraîné par moteur du côté sortie (133), et un second rouleau entraîné par moteur du côté sortie (137) dont la vitesse circonférentielle est commandée sur la base d'une tension du long substrat (52, 114) mesurée par le second rouleau de mesure de tension du côté sortie (135),
une tension du long substrat (52, 114) entré vers le rouleau scellé (56, 131) dans la direction de l'entrée est réglée par une commande à deux niveaux, en utilisant une tension d'entrée (Tu1) définie sur la base d'une différence de vitesse circonférentielle entre le rouleau scellé (56, 131) et le premier rouleau entraîné par moteur du côté entrée (129), et une tension d'entrée (Tu2) (Tu1 > Tu2) définie sur la base d'une différence de vitesse circonférentielle entre le premier rouleau entraîné par moteur du côté entrée (129) et le second rouleau entraîné par moteur du côté entrée (125), et
une tension du long substrat (52, 114) sorti du rouleau scellé (56, 131) dans la direction de la sortie est réglée par une commande à deux niveaux, en utilisant une tension de sortie (Td1) définie sur la base d'une différence de vitesse circonférentielle entre le premier rouleau entraîné par moteur du côté sortie (133) et le rouleau scellé (56, 131), et une tension de sortie (Td2) (Td1 > Td2) définie sur la base d'une différence de vitesse circonférentielle entre le second rouleau entraîné par moteur du côté sortie (137) et le premier rouleau entraîné par moteur du côté sortie (133).

2. Appareil de traitement de long substrat selon la revendication 1, **caractérisé en ce que**
le joint rotatif (20) comprend une unité de bague rotative (21) et une unité de bague fixe (22) prévues sur le même axe que le rouleau scellé (56, 131) et comprenant chacune une surface de contact de coulissement de commande de gaz formée perpendiculairement à un axe central (56a) du rouleau scellé (56, 131),
l'unité de bague rotative (21) comprend une pluralité de canaux d'alimentation en gaz (23) communiquant avec la pluralité de canaux d'introduction de gaz (14) dans le rouleau scellé (56, 131), respectivement, la pluralité de canaux d'alimentation en gaz (23) comprennent chacun une partie d'ouverture tournante (23a) sur la surface de contact de coulissement de commande de gaz de l'unité de bague rotative (21), la partie d'ouverture tournante (23a) s'ouvre à une position angulaire correspondant à une position angulaire sur la surface périphérique extérieure du rouleau scellé (56, 131) du canal d'introduction de gaz (14) communiquant avec le canal d'alimentation en gaz (23),
l'unité de bague fixe (22) comprend un canal de distribution de gaz (27) formé par une rainure annulaire en creux (27a), comprenant une partie fermée fixe et une partie d'ouverture fixe, et communiquant avec un tuyau d'alimentation (26) à l'extérieur de la chambre à vide, la rainure annulaire en creux (27a) est prévue dans la surface de contact de coulissement de commande de gaz de l'unité de bague fixe (22) de manière à s'étendre dans la direction circonférentielle, la partie fermée fixe est une partie au niveau de laquelle la surface de contact de coulissement de commande de gaz de l'unité de bague fixe (22) est fermée par un élément de garniture arqué (42) ajusté dans une région prédéterminée à l'intérieur de la rainure annulaire en creux (27a), la partie d'ouverture fixe est une partie au niveau de laquelle la surface de contact de coulissement de commande de gaz n'est pas fermée, et
la partie d'ouverture fixe s'ouvre dans une plage angulaire dans une région sur la surface de contact de coulissement de commande de gaz de l'unité de bague fixe (22) à laquelle font face les parties d'ouvertures tournantes (23a) de l'unité de bague rotative (21), la plage angulaire est une plage dans laquelle le long substrat (52, 114) est enveloppé.

3. Appareil de traitement de long substrat selon la revendication 1, **caractérisé en ce que**
le joint rotatif (20) comprend une unité de bague rotative (21) ayant une section transversale en forme de T et comprenant une pièce de base cylindrique (21a) et une pièce cylindrique saillante (21b) prévues sur le même axe que le rouleau scellé (56, 131), et une unité de bague fixe (22) cylindrique dans laquelle la pièce cylindrique saillante (21b) de l'unité de bague rotative (21) est ajustée de sorte que la pièce cylindrique saillante (21b) et l'unité de bague fixe (22) comprennent chacune une surface de contact de coulissement de commande de gaz parallèle à un axe central (56a) du rouleau scellé (56, 131),
l'unité de bague rotative (21) comprend une pluralité de canaux d'alimentation en gaz (23) communiquant avec la pluralité de canaux d'introduction de gaz (14) dans le rouleau scellé (56, 131), respectivement, la pluralité de canaux d'alimentation en gaz (23) comprennent chacun une partie d'ouverture tournante (23a) sur la surface de contact de coulissement de commande de gaz de la pièce cylindrique saillante (21b) de l'unité de bague rotative (21), la partie d'ouverture tournante (23a) s'ouvre à une position angulaire correspondant à une position angulaire sur la surface périphérique extérieure du rouleau scellé (56, 131) du canal d'introduction de gaz (14) communiquant avec le canal d'alimentation en gaz (23),
l'unité de bague fixe (22) comprend un canal de distribution de gaz (27) formé par une rainure annulaire en creux (27a), comprenant une partie fermée fixe et une partie d'ouverture fixe, et communiquant avec un tuyau d'alimentation (26) à l'extérieur de la chambre à vide, la rainure annulaire en creux (27a) est prévue dans une surface circonférentielle intérieure cylindrique de l'unité de bague fixe (22), de manière à s'étendre dans la direction circonférentielle, la partie fermée fixe est une partie au niveau de laquelle la surface de contact de coulissement de commande de gaz de l'unité de bague fixe (22) est fermée par un élément de garniture arqué (42) ajusté dans une région prédéterminée à l'intérieur de la rainure annulaire en creux (27a), la partie d'ouverture fixe est une partie au niveau de laquelle la surface de contact de coulissement de commande de gaz n'est pas fermée, et
la partie d'ouverture fixe s'ouvre dans une plage angulaire dans une région sur la surface de contact de coulissement de commande de gaz de l'unité de bague fixe (22) à laquelle font face les parties d'ouvertures tournantes (23a) de la pièce cylindrique saillante (21b) de l'unité de bague rotative (21), la plage angulaire est une plage dans laquelle le long substrat (52, 114) est enveloppé.

4. Appareil de traitement de long substrat selon l'une quelconque des revendications 1 à 3, **caractérisé en ce que** le traitement qui applique une charge thermique est un traitement où un moyen de dépôt sous vide fait face à un chemin de transfert défini sur la surface périphérique extérieure du rouleau scellé (56, 131).

5. Appareil de traitement de long substrat selon la revendication 4, **caractérisé en ce que** le moyen de dépôt sous vide comprend une cathode de pulvérisation magnétron.

6. Procédé de traitement de long substrat qui utilise :
une zone de déroulement dans laquelle est déroulé un long substrat (52, 114) enroulé autour d'un rouleau de déroulement (115),
une zone de traitement dans laquelle est effectué un traitement qui applique une charge thermique dans une chambre à vide sur le long substrat (52, 114) acheminé par la zone de déroulement, et
une zone d'enroulement dans laquelle est enroulé le long substrat (52, 114) soumis au traitement,
le procédé de traitement de long substrat comprenant les étapes consistant à
former la zone de traitement à partir de
un rouleau scellé entraîné par moteur (56, 131) qui refroidit le long substrat (52, 114), transféré de rouleau à rouleau, et enveloppé sur une surface périphérique extérieure du rouleau scellé (56, 131),
un groupe de rouleaux de commande de tension du côté entrée et un groupe de rouleaux de commande de tension du côté sortie, prévus sur un côté entrée et un côté sortie du rouleau scellé (56, 131), où le long substrat (52, 114) est entré vers et sorti du rouleau scellé (56, 131), respectivement, et
des moyens de traitement par application de charge thermique (139, 140, 141, 142), positionnés de manière à faire face à la surface périphérique extérieure du rouleau scellé (56, 131),
agencer une pluralité de canaux d'introduction de gaz (14), sur toute une circonférence du rouleau scellé (56, 131), à des intervalles sensiblement égaux, dans une direction circonférentielle, la pluralité de canaux d'introduction de gaz (14) comprennent chacun une pluralité de trous de décharge de gaz (15) s'ouvrant vers la surface périphérique extérieure, à des intervalles sensiblement égaux, le long d'une direction d'un arbre rotatif (12) du rouleau scellé (56, 131), et
fournir un joint rotatif (20) au rouleau scellé, pour assurer l'alimentation en gaz, de l'extérieur de la chambre à vide aux canaux d'introduction de gaz (14) situés dans une plage angulaire de la surface périphérique extérieure du rouleau scellé (56, 131), dans laquelle le long substrat (52, 114) est enveloppé, et pour ne pas assurer d'alimentation en gaz, de l'extérieur de la chambre à vide aux canaux d'introduction de gaz (14) qui ne sont pas situés dans la plage angulaire dans laquelle le long substrat (52, 114) est enveloppé,
**caractérisé en ce que** le procédé de traitement de long substrat comprend les étapes consistant à :
former le groupe de rouleaux de commande de tension du côté entrée à partir d'un premier groupe de rouleaux de commande de tension du côté entrée et d'un second groupe de rouleaux de commande de tension du côté entrée, prévus chacun dans la zone de traitement, le premier groupe de rouleaux de commande de tension du côté entrée comprend un premier rouleau de mesure de tension du côté entrée (130) disposé près du côté entrée du rouleau scellé (56, 131), et un premier rouleau entraîné par moteur du côté entrée (129) dont la vitesse circonférentielle est commandée sur la base d'une tension du long substrat (52, 114) mesurée par le premier rouleau de mesure de tension du côté entrée (130), le second groupe de rouleaux de commande de tension du côté entrée comprend un second rouleau de mesure de tension du côté entrée (127) disposé sur le côté du premier rouleau entraîné par moteur du côté entrée (129), et un second rouleau entraîné par moteur du côté entrée (125) dont la vitesse circonférentielle est commandée sur la base d'une tension du long substrat (52, 114) mesurée par le second rouleau de mesure de tension du côté entrée (127) ;
former le groupe de rouleaux de commande de tension du côté sortie à partir d'un premier groupe de rouleaux de commande de tension du côté sortie et d'un second groupe de rouleaux de commande de tension du côté sortie, prévus chacun dans la zone de traitement, le premier groupe de rouleaux de commande de tension du côté sortie comprend un premier rouleau de mesure de tension du côté sortie (132) disposé près du côté sortie du rouleau scellé (56, 131), et un premier rouleau entraîné par moteur du côté sortie (133) dont la vitesse circonférentielle est commandée sur la base d'une tension du long substrat (52, 114) mesurée par le premier rouleau de mesure de tension du côté sortie (132), le second groupe de rouleaux de commande de tension du côté sortie comprend un second rouleau de mesure de tension du côté sortie (135) disposé sur le côté du premier rouleau entraîné par moteur du côté sortie (133), et un second rouleau entraîné par moteur du côté sortie (137) dont la vitesse circonférentielle est commandée sur la base d'une tension du long substrat (52, 114) mesurée par le second rouleau de mesure de tension du côté sortie (135) ;
régler une tension du long substrat (52, 114) entré vers le rouleau scellé (56, 131) dans la direction de l'entrée par une commande à deux niveaux, en utilisant une tension d'entrée (Tu1) définie sur la base d'une différence de vitesse circonférentielle entre le rouleau scellé (56, 131) et le premier rouleau entraîné par moteur du côté entrée (129), et une tension d'entrée (Tu2) (Tu1 > Tu2) définie sur la base d'une différence de vitesse circonférentielle entre le premier rouleau entraîné par moteur du côté entrée (129) et le second rouleau entraîné par moteur du côté entrée (125) ; et
régler une tension du long substrat (52, 114) sorti du rouleau scellé (56, 131) dans la direction de la sortie par une commande à deux niveaux, en utilisant une tension de sortie (Td1) définie sur la base d'une différence de vitesse circonférentielle entre le premier rouleau entraîné par moteur du côté sortie (133) et le rouleau scellé (56, 131), et une tension de sortie (Td2) (Td1 > Td2) définie sur la base d'une différence de vitesse circonférentielle entre le second rouleau entraîné par moteur du côté sortie (137) et le premier rouleau entraîné par moteur du côté sortie (133).
